(19) Europäisches Patentamt / European Patent Office / Office européen des brevets

(11) **EP 3 811 424 B1**

(12) **FASCICULE DE BREVET EUROPEEN**

(45) Date de publication et mention
de la délivrance du brevet:
**29.05.2024 Bulletin 2024/22**

(21) Numéro de dépôt: **19745698.1**

(22) Date de dépôt: **21.06.2019**

(51) Classification Internationale des Brevets (IPC):
**H10N 30/85** *(2023.01)*    **H10N 30/87** *(2023.01)*
**B60C 19/00** *(2006.01)*

(52) Classification Coopérative des Brevets (CPC):
**B60C 19/00; H10N 30/852; H10N 30/878**

(86) Numéro de dépôt international:
**PCT/FR2019/051514**

(87) Numéro de publication internationale:
**WO 2019/243750 (26.12.2019 Gazette 2019/52)**

(54) **DISPOSITIF EN MATRICE ÉLASTOMÈRE COMPRENANT DES CHARGES PIÉZOÉLECTRIQUES ET DES ÉLECTRODES**

VORRICHTUNG BESTEHEND AUS EINER ELASTOMERMATRIX MIT PIEZOELEKTRISCHEN LADUNGEN UND ELEKTRODEN

DEVICE CONSISTING OF AN ELASTOMER MATRIX, COMPRISING PIEZOELECTRIC CHARGES AND ELECTRODES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.06.2018 FR 1855535**

(43) Date de publication de la demande:
**28.04.2021 Bulletin 2021/17**

(73) Titulaire: **COMPAGNIE GENERALE DES ETABLISSEMENTS MICHELIN**
**63000 Clermont-Ferrand (FR)**

(72) Inventeurs:
• **LAFORT, François**
  **63040 Clermont Ferrand Cedex 9 (FR)**
• **LEBRUN, Xavier**
  **63040 Clermont Ferrand Cedex 9 (FR)**
• **PIBRE, Guillaume**
  **63040 Clermont Ferrand Cedex 9 (FR)**

(74) Mandataire: **M.F.P. Michelin**
**DCJ/PI - F35 - Ladoux**
**23 place des Carmes-Déchaux**
**63040 Clermont-Ferrand Cedex 9 (FR)**

(56) Documents cités:
**DE-T5-112016 000 917    JP-A- 2013 225 608**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

La présente invention concerne un dispositif comprenant un composite piézoélectrique et des composites conducteurs jouant le rôle d'électrodes, chacun de ces composites étant à base d'une matrice élastomérique. La piézoélectricité se développe dans des matériaux tels que les cristaux, certains polymères semi-cristallins et des céramiques piézoélectriques. Ce phénomène physique correspond à l'apparition d'une polarisation électrique induite par une déformation mécanique extérieure. Il s'agit d'un couplage électromécanique où la polarisation est proportionnelle à la contrainte mécanique appliquée jusqu'à un certain niveau. L'effet piézoélectrique est alors dit direct. Ce phénomène est réversible : lorsque le matériau est soumis à un champ électrique extérieur, il se déforme. Il s'agit de l'effet piézoélectrique inverse.

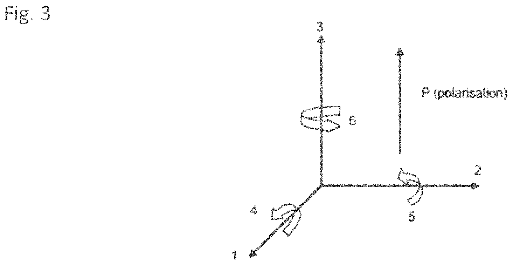

Une variation de la polarisation macroscopique lors de l'application d'une contrainte sur l'échantillon caractérise l'effet piézoélectrique. Dans un système d'axes orthogonaux, la polarisation et la contrainte sont liées en notation matricielle par un tenseur de rang 2 appelé tenseur piézoélectrique $d_{ij}$ avec i=1, 2, 3 et j=1, 2, 3, 4, 5, 6, correspondant respectivement à l'axe de polarisation et d'application de la contrainte comme indiqué sur la figure 3.

Un composite piézoactif ou piézoélectrique comprend au moins un matériau piézoélectrique, qui confère au composite son activité piézoélectrique, et une ou plusieurs phases non piézoélectriques. Cette association conduit à un matériau dont les performances sont accrues par rapport à chaque phase seule. La phase non piézoélectrique est en général une matrice polymère organique, notamment une matrice polymère rigide thermoplastique ou thermodurcissable (US 2015134061, WO 2016/157092), qui peut être de type polyamide (Capsal et al. Journal of non-crystalline solids 2010, 356, 629-634), polyépoxy (Furukawa et al. Jpn. J. Appl. Phys. 1976, 15, 2119), polystyrène, polyuréthane (Hanner et al. Ferroelectrics 1989, 100, 255-260), PVC (Liu et al. Materials Science and Engineering 2006, 127, 261-266) ou encore polyéthylène (Rujijanagul et al. Journal of Materials Science Letters 2001, 20, 1943-1945), ou une matrice polymérique comprenant de l'alcool polyvinylique cyanoéthylé (EP 2654094). La phase non piézoélectrique peut également comprendre un élastomère ou un élastomère thermoplastique, adhéré à la phase piézoélectrique par laminage (DE 11 2016 000 917 T5). Ainsi, un composite piézoélectrique permet de maximiser l'électroactivité de la matrice polymère, mais généralement cette association restreint également sa gamme de déformation.

Dans le domaine des pneumatiques, des dispositifs incluant des composites piézoélectriques sont utilisés comme appareil de production d'énergie à l'intérieur d'un pneu Ces dispositifs permettent de remplacer des batteries conventionnelles à durée limitée. Notamment, le matériau piézoélectrique peut être incrusté dans une matrice époxy (WO 03/095244 Michelin) ou bien dans une matrice polymère thermoplastique, plastique ou piézoélectrique (US 2011/0074564) ou dans une matrice élastomérique (JP 2013/225608).

Il serait avantageux de pouvoir intégrer un dispositif piézoélectrique dans un pneumatique afin de suivre l'état d'usure de ce pneumatique, de détecter et localiser les chocs subis par le pneumatique, tel qu'un choc trottoir sur les flancs ou les chocs nids de poule au sommet. L'invention vise à proposer un dispositif qui présente à la fois des propriétés piézoélectriques mais également des propriétés mécaniques compatibles avec son intégration dans un pneumatique, en particulier de résistance à la déformation et à l'allongement.

L'invention vise à proposer un dispositif qui puisse être soit adhéré, par exemple collé, au pneumatique, déjà cuit, soit intégré au pneumatique avant cuisson de ce dernier et ainsi co-réticulé avec les autres élastomères présents. La présente invention a pour objet un dispositif comprenant au moins une couche P composite piézoélectrique intercalée entre deux couches E composites conductrices, chaque couche E formant une électrode, caractérisé en ce que

- la couche P est une composition de caoutchouc à base :

  - de plus de 50 parties en poids pour cent parties en poids d'élastomère, pce, d'élastomère diénique,
  - d'un système de réticulation,
  - d'au moins 5% en volume, par rapport au volume total de la composition de caoutchouc, de charges inorganiques piézoélectriques ;

- chaque couche E est une composition de caoutchouc à base :

  - d'au moins 50 pce d'élastomère diénique,
  - d'un système de réticulation,
  - de charges conductrices ;

l'élastomère diénique de la couche P étant co-réticulé avec l'élastomère diénique de chaque couche E. Le dispositif selon l'invention comprend donc un composite piézoélectrique avec ses deux électrodes. Chaque électrode est également un composite.

Un dispositif en matrice élastomérique selon l'invention présente des propriétés électroactives et mécaniques particulières. Sa formulation permet de conférer souplesse et élasticité au dispositif tout en conservant un caractère piézoélectrique suffisant pour son application en tant que dispositif électronique, en particulier en tant que dispositif électronique dans un pneumatique.

Les propriétés électromécaniques particulières du dispositif selon l'invention telles que sa souplesse, son élasticité et sa génération de charges électriques présentent des avantages majeurs par rapport aux dispositifs comprenant des composites électroactifs en matrice thermodurcissable ou thermoplastique.

L'élasticité permet des points de fonctionnement différents impossibles avec des matrices thermodurcissables ou thermoplastiques cassants ou présentant une déformation plastique.

La génération de charges électriques à polarisation identique est plus importante avec une contrainte plus faible.

Selon l'invention, l'élastomère diénique de la couche P est co-réticulé avec l'élastomère diénique de chaque couche E. Ainsi, les différentes couches sont avantageusement liées entre-elles de manières covalentes, ce qui permet d'améliorer la cohésion des couches co-réticulées.

Dans la couche P, le taux de charges inorganiques piézoélectriques varie avantageusement de 5% à 80% en volume par rapport au volume total de matrice élastomère, plus avantageusement de 5% à 60%, encore plus avantageusement encore de 5% à 50 %.

Dans la couche P, la taille des charges inorganiques piézoélectriques varie avantageusement de 50 nm à 500 $\mu$m.

Les charges inorganiques piézoélectriques sont avantageusement des céramiques piézoélectriques, plus avantageusement des oxydes ferroélectriques, avantageusement ayant une structure perovskite. En particulier, les charges inorganiques piézoélectriques sont choisies dans le groupe comprenant les charges de titanate de baryum, titanate de plomb, titano-zirconate de plomb (PZT), niobate de plomb, niobate de lithium et niobate de potassium, avantageusement les charges inorganiques piézoélectriques sont des charges de titanate de baryum.

La composition de caoutchouc de la couche P comprend avantageusement de 75 pce à 100 pce, plus avantageusement de 90 pce à 100 pce, d'élastomère diénique.

Le système de réticulation de la composition de caoutchouc de la couche P et/ou d'une ou chaque composition de caoutchouc de la couche E est avantageusement choisi dans le groupe constitué par les peroxydes et leurs mélanges, en particulier les peroxydes organiques.Le peroxyde organique est avantageusement choisi dans le groupe constitué par les peroxydes de dialkyle, les monoperoxycarbonates, les peroxydes de diacyle, les perox-ycétales, les peroxyesters, et leurs mélanges.

Dans une ou dans chaque couche E le taux de charges conductrices varie avantageusement de 10% à 40% en volume par rapport au volume total de matrice élastomère, plus avantageusement de 15% à 30%.

Les charges conductrices sont avantageusement du noir de carbone graphité ou partiellement graphité.

L'invention a également pour objet un procédé de préparation d'un dispositif selon l'invention polarisé, comprenant une étape de polarisation à une température de polarisation inférieure d'au moins 5°C à la température de Curie, Tc, la plus faible des charges inorganiques piézoélectriques.

L'invention a également pour objet un procédé de préparation d'un dispositif selon l'invention comprenant les étapes suivantes :

(a1) Placer au moins une couche P composite piézoélectrique entre deux couches E, identiques ou différentes, composites conductrices, pour obtenir un assemblage ;

(a2) Appliquer une pression sur l'assemblage obtenu suite à l'étape (a1) ;

(a3) Réticuler l'assemblage pour obtenir ledit dispositif.

Le procédé comprend avantageusement une étape de polarisation (a4) du dispositif obtenu suite à l'étape (a3), avantageusement à une température de polarisation inférieure d'au moins 5°C à la température de Curie, Tc, la plus faible des charges inorganiques piézoélectriques.

La couche composite piézoélectrique peut être préparée par un procédé comprenant les étapes suivantes :

(b1) incorporer à un élastomère diénique, dans un mélangeur, une charge inorganique piézoélectrique en malaxant thermomécaniquement le tout, en une ou plusieurs fois, jusqu'à atteindre une température maximale comprise entre 80°C et 190°C ;

(b2) refroidir l'ensemble à une température inférieure à 80°C ;

(b3) incorporer ensuite un système de réticulation ;

(b4) malaxer le tout jusqu'à une température maximale inférieure à 80°C ;

(b5) calandrer ou extruder la composition de caoutchouc ainsi obtenue sous la forme d'une bande.

Chaque couche E composite conductrice peut être préparée par un procédé comprenant les étapes suivantes :

(c1) incorporer à un élastomère diénique, dans un mélangeur, une charge conductrice en malaxant thermomécaniquement le tout, en une ou plusieurs fois, jusqu'à atteindre une température maximale comprise entre 110°C et 190°C ;

(c2) refroidir l'ensemble à une température inférieure à 100°C ;

(c3) incorporer ensuite un système de réticulation ;

(c4) malaxer le tout jusqu'à une température maximale inférieure à 110°C ;

(c5) calandrer ou extruder la composition de caoutchouc ainsi obtenue sous la forme d'une bande.

L'invention a également pour objet un pneumatique comprenant un dispositif selon l'invention.

L'invention a également pour objet l'utilisation du dispositif selon l'invention, en association avec un capteur.

## DESCRIPTION DES FIGURES

D'autres caractéristiques et avantages de l'invention ressortiront encore de la description qui suit, laquelle est purement illustrative et non limitative, et doit être lue en regard des figures annexées sur lesquelles :

- la figure 1 est une représentation schématique en coupe radiale d'un pneumatique selon l'invention ;
- la figure 2 est une représentation schématique de coté d'un pneumatique selon l'invention ;
- la figure 3 est une représentation du système d'axes orthogonaux pour la polarisation, P, et la contrainte.

## Mesures et tests utilisés

- Confection des éprouvettes

Pour la réalisation du dispositif comprenant successivement une couche E, une couche P puis une couche E, un moule de cuisson est utilisé. Sont disposées successivement dans ce moule de cuisson:

- la couche E sous la forme d'une plaque de dimension 100mm x 100 mm x 1mm (Lxlxe),
- la couche P sous la forme d'une plaque de dimension 100mm x 100 mm x 2mm (Lxlxe),
- la couche E sous la forme d'une plaque de dimension 100mm x 100 mm x 1mm (Lxlxe),

Ensuite, le moule est placé dans une presse à plateaux où les matériaux sont cuits à 170°C sous 12 tonnes de pression pendant 20 minutes.

A l'issue de cette opération, il est tout à fait possible de découper le dispositif avec un emporte-pièce ou tout autre moyen de découpe pour réaliser un dispositif, en l'occurrence un composite piézoélectrique avec ses deux électrodes, à la forme et la taille souhaitée.

- Polarisation des échantillons

Le signal de sortie d'un générateur à faible intensité est appliqué aux bornes de l'éprouvette (i.e. connecté aux 2 couches E). Les éprouvettes sont ainsi polarisées sous un champ électrique continu de 4 kV, à la température de 100°C et pendant 60 minutes. Une fois polarisé, l'échantillon est court-circuité pour évacuer un maximum de charges résiduelles.

- Matériel et mesure

La mesure de la réponse électromécanique de ces matériaux (caractérisation en déformation, caractérisation en cyclage) s'effectue sur un banc de mesures dynamiques. L'échantillon est pré-étiré de 1% puis il est sollicité en extension de 1 à plusieurs % en déformation à la fréquence indiquée dans les exemples et à température ambiante.

Le signal généré par le piézocomposite est récupéré aux bornes de l'échantillon par un appontage de mors spécifique, puis amplifié et mesuré sur un oscilloscope.

A partir de la tension crête crête lue sur l'oscilloscope, on en déduit la charge Q (pC) libérée à chaque sollicitation mécanique. Ainsi le coefficient piézoélectrique $d31$ (pC/N) peut être calculé. Le coefficient $d31$, connu de l'homme de l'art, représente le coefficient mesuré par application d'une contrainte dans la direction orthogonale à la direction de polarisation de l'échantillon. Dans le cas d'un échantillon parallélépipédique, la direction de polarisation correspond à la plus faible épaisseur (direction 3) et l'application de la contrainte se fait selon la plus grande longueur (direction 1).

La notation suivante peut être adoptée :

$$d31 = \Delta P3 / \Delta\sigma1,$$

avec $\Delta P3$ représentant la variation de polarisation macroscopique dans la direction 3 et $\Delta\sigma1$ représentant la contrainte appliquée dans la direction 1.

Le calcul de ce coefficient se fait par la formule suivante :

$$d31 = [Q\ (pC) \times épaisseur\ (m)] / [Force\ (N) \times Longueur\ (m)]$$

dans le cas où l'électrode couvre l'entièreté de la surface de l'éprouvette.

- Détermination de la masse moléculaire des élastomères

La technique SEC (chromatographie d'exclusion par la taille) est utilisée pour déterminer les distributions de masses moléculaires des élastomères.

A partir de produits étalons dont les caractéristiques sont décrites dans l'exemple 1 du document de brevet européen EP-A-692 493, cette technique a permis d'évaluer pour un échantillon une masse moléculaire en nombre.

Selon cette technique, on sépare physiquement les macromolécules suivant leurs tailles respectives à l'état gonflé, dans des colonnes remplies d'une phase stationnaire poreuse. Avant de mettre en oeuvre cette séparation, on solubilise l'échantillon de polymère à une concentration d'environ 1 g/L dans du tétrahydrofurane.

On utilise pour la séparation précitée un chromatographe de dénomination « WATERS » et sous le modèle « 150C ». Le solvant d'élution est le tétrahydrofurane, le débit est de 1°ml/min, la température du système est de 35°C et la durée d'analyse est de 30 min. On utilise un jeu de deux colonnes « WATERS » de type « STYRAGEL HT6E ».

Le volume injecté de la solution d'échantillon de polymère est de 100 $\mu$l. Le détecteur est un réfractomètre différentiel « WATERS » dont le modèle est «R401 ». On utilise également un logiciel d'exploitation des données chromatographiques « WATERS MILLENIUM ».

**Description détaillée**

Dans la présente description, tout intervalle de valeurs désigné par l'expression « de a à b » représente le domaine de valeurs allant de a jusqu'à b (c'est-à-dire bornes a et b inclues). Tout intervalle « entre a et b » représente le domaine de valeurs allant de plus de a à moins de b (c'est-à-dire bornes a et b exclues).

Par particules non liées à l'élastomère diénique, on entend des particules sans liaisons covalentes entre la charge inorganique piézoélectrique et l'élastomère diénique.

Par « pce », on entend « parties en poids pour cent parties en poids d'élastomère », l'élastomère comprend l'élastomère diénique et tout autre élastomère éventuel, incluant des élastomères thermoplastiques.

Par l'expression « composition à base de » il faut entendre une composition comportant le mélange et/ou le produit de réaction in situ des différents constituants de base utilisés, certains de ces constituants pouvant réagir et/ou étant destinés à réagir entre eux, au moins partiellement, lors des différentes phases de fabrication de la composition, ou lors de la cuisson ultérieure, modifiant la composition telle qu'elle est préparée au départ. Ainsi les compositions telles que mises en oeuvre pour l'invention peuvent être différentes à l'état non réticulé et à l'état réticulé.

Les composés mentionnés dans la description et entrant dans la préparation de polymères ou de compositions de caoutchouc peuvent être d'origine fossile ou biosourcés. Dans ce dernier cas, ils peuvent être, partiellement ou totalement, issus de la biomasse ou obtenus à partir de matières premières renouvelables issues de la biomasse. Sont concernés notamment les polymères, les plastifiants, les charges....

1. Composition de caoutchouc de la couche P

La couche P est une composition de caoutchouc à base :

- de plus de 50 parties en poids pour cent parties en poids d'élastomère, pce, d'élastomère diénique,
- d'un système de réticulation,
- d'au moins 5% en volume, par rapport au volume total de la composition de caoutchouc, de charges inorganiques piézoélectriques.

## 1.1 Elastomère diénique

Par élastomère (ou indistinctement caoutchouc) "diénique", qu'il soit naturel ou synthétique, doit être compris de manière connue un élastomère constitué au moins en partie (i.e., un homopolymère ou un copolymère) d'unités monomères diènes (monomères porteurs de deux doubles liaisons carbone-carbone, conjuguées ou non). Ces élastomères diéniques peuvent être classés dans deux catégories : "essentiellement insaturés" ou "essentiellement saturés". On entend en général par "essentiellement insaturé", un élastomère diénique issu au moins en partie de monomères diènes conjugués, ayant un taux de motifs ou unités d'origine diénique (diènes conjugués) qui est supérieur à 15% (% en moles) ; c'est ainsi que des élastomères diéniques tels que les caoutchoucs butyle ou les copolymères de diènes et d'alpha-oléfines type EPDM n'entrent pas dans la définition précédente et peuvent être notamment qualifiés d'élastomères diéniques "essentiellement saturés" (taux de motifs d'origine diénique faible ou très faible, toujours inférieur à 15%).

On entend particulièrement par élastomère diénique susceptible d'être utilisé dans les compositions conformes à l'invention :

(a) - tout homopolymère d'un monomère diène, conjugué ou non, ayant de 4 à 18 atomes de carbone ;
(b) - tout copolymère d'un diène, conjugué ou non, ayant de 4 à 18 atomes de carbone et d'au moins un autre monomère.

L'autre monomère peut être l'éthylène, une oléfine ou un diène, conjugué ou non.

A titre de diènes conjugués conviennent les diènes conjugués ayant de 4 à 12 atomes de carbone, en particulier les 1,3-diènes, tels que notamment le 1,3-butadiène et l'isoprène. A titre de diènes non conjugués conviennent les diènes non conjugués ayant de 6 à 12 atomes de carbone, tels que le 1,4-hexadiène, l'éthylidène norbornène, le dicyclopentadiène.

A titre d'oléfines conviennent les composés vinylaromatiques ayant de 8 à 20 atomes de carbone et les $\alpha$-monooléfines aliphatiques ayant de 3 à 12 atomes de carbone.

A titre de composés vinylaromatiques conviennent par exemple le styrène, l'ortho-, méta-, para-méthylstyrène, le mélange commercial "vinyle-toluène", le para-tertiobutylstyrène.

A titre d'$\alpha$-monooléfines aliphatiques conviennent notamment les $\alpha$-monooléfines aliphatiques acycliques ayant de 3 à 18 atomes de carbone.

Plus particulièrement, l'élastomère diénique est :

(a') - tout homopolymère d'un monomère diène conjugué, notamment tout homopolymère obtenu par polymérisation d'un monomère diène conjugué ayant de 4 à 12 atomes de carbone;
(b') - tout copolymère obtenu par copolymérisation d'un ou plusieurs diènes conjugués entre eux ou avec un ou plusieurs composés vinylaromatiques ayant de 8 à 20 atomes de carbone;
(c') - un copolymère d'isobutène et d'isoprène (caoutchouc butyle), ainsi que les versions halogénées, en particulier chlorées ou bromées, de ce type de copolymère.
(d') - tout copolymère obtenu par copolymérisation d'un ou plusieurs diènes, conjugués ou non, avec l'éthylène, une $\alpha$-monooléfine ou leur mélange comme par exemple les élastomères obtenus à partir d'éthylène, de propylène avec un monomère diène non conjugué du type précité,

Préférentiellement, l'élastomère diénique est choisi dans le groupe constitué par les polybutadiènes (BR), le caoutchouc naturel (NR), les polyisoprènes de synthèse (IR), les copolymères de butadiène, les copolymères d'isoprène, et les mélanges de ces élastomères. Les copolymères de butadiène sont particulièrement choisis dans le groupe constitué par les copolymères de butadiène-styrène (SBR).

Par "élastomère isoprénique", on entend de manière connue un homopolymère ou un copolymère d'isoprène, en d'autres termes un élastomère diénique choisi dans le groupe constitué par le caoutchouc naturel (NR), les polyisoprènes de synthèse (IR), les différents copolymères d'isoprène et les mélanges de ces élastomères. Parmi les copolymères d'isoprène, on citera en particulier les copolymères d'isobutène-isoprène (caoutchouc butyle - IIR), d'isoprène-styrène (SIR), d'isoprène-butadiène (BIR) ou d'isoprène-butadiène-styrène (SBIR). Cet élastomère isoprénique est de préférence du caoutchouc naturel ou un polyisoprène cis-1,4 de synthèse; parmi ces polyisoprènes de synthèse, sont utilisés de préférence des polyisoprènes ayant un taux (% molaire) de liaisons cis-1,4 supérieur à 90%, plus préférentiellement encore supérieur à 98%.

Par "élastomère butadiénique", on entend de manière connue un homopolymère ou un copolymère du butadiène, en particulier un élastomère diénique choisi dans le groupe constitué par les polybutadiènes (BR), les différents copolymères du butadiène et les mélanges de ces élastomères. Parmi les copolymères du butadiène, on citera en particulier les copolymères de butadiène-styrène (SBR), d'isoprène-butadiène (BIR) ou d'isoprène-butadiène-styrène (SBIR). Cet élastomère butadiénique est de préférence un polybutadiène cis-1,4; parmi ces polybutadiènes sont utilisés de préférence des polybutadiènes ayant un taux (% molaire) de liaisons cis-1,4 supérieur à 90%, plus préférentiellement encore supérieur à 96%.

Conviennent les polybutadiènes et en particulier ceux ayant une teneur (% molaire) en unités -1,2 comprise entre 4% et 80% ou ceux ayant une teneur (% molaire) en cis-1,4 supérieure à 80%, les polyisoprènes, les copolymères de butadiène-styrène et en particulier ceux ayant une Tg (température de transition vitreuse (Tg, mesurée selon ASTM D3418-99) comprise entre 0°C et - 90°C et plus particulièrement entre - 10°C et - 70°C, une teneur en styrène comprise entre 1% et 60% en poids et plus particulièrement entre 20% et 50%, une teneur (% molaire) en liaisons -1,2 de la partie butadiénique comprise entre 4% et 75%, une teneur (% molaire) en liaisons trans-1,4 comprise entre 10% et 80%, les copolymères de butadiène-isoprène et notamment ceux ayant une teneur en isoprène comprise entre 5% et 90% en poids et une Tg de - 40°C à - 80°C, les copolymères isoprène-styrène et notamment ceux ayant une teneur en styrène comprise entre 5% et 50% en poids et une Tg comprise entre - 5 C et - 50°C. Dans le cas des copolymères de butadiène-styrène-isoprène conviennent notamment ceux ayant une teneur en styrène comprise entre 5% et 50% en poids et plus particulièrement comprise entre 10% et 40%, une teneur en isoprène comprise entre 15% et 60% en poids et plus particulièrement entre 20% et 50%, une teneur en butadiène comprise entre 5% et 50% en poids et plus particulièrement comprise entre 20% et 40%, une teneur (% molaire) en unités -1,2 de la partie butadiénique comprise entre 4% et 85%, une teneur (% molaire) en unités trans -1,4 de la partie butadiénique comprise entre 6% et 80%, une teneur (% molaire) en unités -1,2 plus -3,4 de la partie isoprénique comprise entre 5% et 70% et une teneur (% molaire) en unités trans -1,4 de la partie isoprénique comprise entre 10% et 50%, et plus généralement tout copolymère butadiène-styrène-isoprène ayant une Tg comprise entre - 5°C et - 70°C.

L'élastomère diénique peut être modifié, c'est à dire soit couplé et/ou étoilé, soit fonctionnalisé, soit couplé et/ou étoilé et simultanément fonctionnalisé.

Ainsi, l'élastomère diénique peut être couplé et/ou étoilé, par exemple au moyen d'un atome silicium ou d'étain qui lie entre elles les chaînes élastomères.

L'élastomère diénique peut être simultanément ou alternativement fonctionnalisé et comprendre au moins groupe fonctionnel. Par groupe fonctionnel, on entend un groupe comprenant au moins un hétéroatome choisi parmi Si, N, S, O, P. Conviennent particulièrement à titre de groupes fonctionnels ceux comprenant au moins une fonction telle que : le silanol, un alcoxysilane, une amine primaire, secondaire ou tertiaire, cyclique ou non, un thiol, un époxyde.

Dans le cadre des élastomères fonctionnalisés, c'est-à-dire comprenant au moins un groupe fonctionnel :

- Le groupe fonctionnel peut se situer en extrémité de chaîne élastomère, on dira alors que l'élastomère diénique est fonctionnalisé en bout ou extrémité de chaîne.
- Le groupe fonctionnel peut se situer dans la chaîne élastomère principale linéaire, on dira alors que l'élastomère diénique est couplé ou encore fonctionnalisé en milieu de chaîne, par opposition à la position "en bout de chaîne" et bien que le groupement ne se situe pas précisément au milieu de la chaîne élastomère principale.
- Le groupe fonctionnel peut être central et lier n chaînes élastomères (n>2), l'élastomère étant étoilé ou branché.
- L'élastomère diénique peut comporter plusieurs groupes fonctionnels, pendants ou non, répartis le long de la chaîne principale de l'élastomère, on dira alors que l'élastomère diénique est fonctionnalisé le long de la chaîne.

A titre d'élastomères fonctionnalisés conviennent ceux préparés par l'utilisation d'un amorceur fonctionnel, notamment ceux portant une fonction amine. De tels élastomères fonctionnels et leurs procédés d'obtention sont connus de l'homme de l'art.

A titre d'élastomères fonctionnalisés conviennent également ceux obtenus par copolymérisation d'au moins un monomère diène et d'un monomère portant une fonction. A titre d'élastomères fonctionnalisés conviennent encore ceux obtenus par modification post-polymérisation par réaction avec un agent de fonctionnalisation introduisant au moins une fonction au sein de la structure de l'élastomère. De tels élastomères fonctionnalisés et leurs procédés d'obtention sont connus de l'homme de l'art. Une telle fonctionnalisation peut ainsi être classiquement réalisée par diverses réactions, par exemple par greffage radicalaire sur l'élastomère diénique, par réaction 1,3-dipolaire sur l'élastomère diénique, par réaction de l'élastomère diénique (pseudo)vivant obtenu à l'issue d'une polymérisation, coordinative ou anionique, avec un agent de fonctionnalisation.

La masse moléculaire moyenne en nombre (notée Mn) de l'élastomère diénique varie avantageusement de 50 000 g/mol à 400 000 g/mol, avantageusement de 80 000 g/mol à 370 000 g/mol, encore plus avantageusement de 100 000 g/mol à 150 000 g/mol.

La composition de caoutchouc formant la couche P peut contenir un seul élastomère diénique ou un mélange de plusieurs élastomères diéniques.

Si d'éventuels autres élastomères sont utilisés dans la composition de caoutchouc, le ou les élastomères diéniques constituent la fraction majoritaire en poids ; ils représentent alors plus de 50% en poids, plus préférentiellement au moins 75% en poids par rapport au poids total des élastomères dans la composition de caoutchouc. De manière préférentielle également, le ou les élastomères diéniques représentent au moins 90%, voire 95% (en particulier 100%) en poids par rapport au poids total des élastomères dans la composition de caoutchouc.

L'élastomère diénique est l'élastomère majoritaire en poids de la composition de caoutchouc. Ainsi, la composition de caoutchouc comprend plus de 50 pce d'élastomère diénique, et ainsi de plus de 50 pce à 100 pce d'élastomère diénique, avantageusement de 75 pce à 100 pce, plus avantageusement de 90 pce à 100 pce, encore plus avantageusement de 95 pce à 100 pce, d'élastomère diénique.

Dans une variante préférée de l'invention, l'élastomère diénique, ou le mélange d'élastomères diéniques, est le seul élastomère de la composition de caoutchouc (correspondant ainsi à 100 pce).

### 1.2 Autre élastomère

Dans une autre variante de l'invention, la composition de caoutchouc peut comprendre un autre élastomère, en une teneur strictement inférieure à 50 pce.

Cet autre élastomère peut en particulier être un élastomère thermoplastique (en abrégé « TPE »).

### 1.2.1 Élastomère thermoplastique

Les TPE ont une structure intermédiaire entre polymères thermoplastiques et élastomères. Ce sont des copolymères à blocs, constitués de blocs rigides, thermoplastiques, reliés par des blocs souples, élastomères.

L'élastomère thermoplastique utilisé pour la mise en oeuvre de l'invention est un copolymère à blocs dont la nature chimique des blocs thermoplastiques et des blocs élastomères peut varier.

La masse moléculaire moyenne en nombre (notée Mn) du TPE est préférentiellement comprise entre 30 000 et 500 000 g/mol, plus préférentiellement comprise entre 40 000 et 400 000 g/mol.

La masse moléculaire moyenne en nombre (Mn) de l'élastomère TPE est déterminée de manière connue, par chromatographie d'exclusion stérique (SEC). Par exemple dans le cas des élastomères thermoplastiques styréniques, l'échantillon est préalablement solubilisé dans du tétrahydrofuranne à une concentration d'environ 1 g/l ; puis la solution est filtrée sur filtre de porosité 0,45 $\mu$m avant injection. L'appareillage utilisé est une chaîne chromatographique « WATERS alliance ». Le solvant d'élution est le tétrahydrofuranne, le débit de 0,7 ml/min, la température du système de 35°C et la durée d'analyse de 90 min. On utilise un jeu de quatre colonnes WATERS en série, de dénominations commerciales « STYRAGEL » (« HMW7 », « HMW6E » et deux « HT6E »). Le volume injecté de la solution de l'échantillon de polymère est de 100 $\mu$l. Le détecteur est un réfractomètre différentiel « WATERS 2410 » et son logiciel associé d'exploitation des données chromatographiques est le système « WATERS MILLENIUM ». Les masses molaires moyennes calculées sont relatives à une courbe d'étalonnage réalisée avec des étalons de polystyrène. Les conditions sont adaptables par l'homme du métier.

La valeur de l'indice de polydispersité Ip (rappel : Ip = Mw/Mn avec Mw masse moléculaire moyenne en poids et Mn masse moléculaire moyenne en nombre) du TPE est de préférence inférieure à 3 ; plus préférentiellement inférieure à 2 et encore plus préférentiellement inférieure à 1,5.

De manière connue, les TPE présentent deux pics de température de transition vitreuse (Tg, mesurée selon ASTM D3418), la température la plus basse étant relative à la partie élastomère du TPE, et la température la plus haute étant relative à la partie thermoplastique du TPE. Ainsi, les blocs souples des TPE se définissent par une Tg inférieure à la température ambiante (25°C), tandis que les blocs rigides ont une Tg supérieure à 80°C.

Pour être de nature à la fois élastomère et thermoplastique, le TPE doit être muni de blocs suffisamment incompatibles (c'est-à-dire différents du fait de leur masse, de leur polarité ou de leur Tg respectives) pour conserver leurs propriétés propres de bloc élastomère ou thermoplastique.

Les TPE peuvent être des copolymères avec un petit nombre de blocs (moins de 5, typiquement 2 ou 3), auquel cas ces blocs ont de préférence des masses élevées, supérieures à 15000 g/mol. Ces TPE peuvent être par exemple des copolymères diblocs, comprenant un bloc thermoplastique et un bloc élastomère. Ce sont souvent aussi des élastomères triblocs avec deux segments rigides reliés par un segment souple. Les segments rigides et souples peuvent être disposés linéairement, en étoile ou branchés. Typiquement, chacun de ces segments ou blocs contient souvent au minimum plus de 5, généralement plus de 10 unités de base (par exemple unités styrène et unités butadiène pour un copolymère blocs styrène/ butadiène/ styrène).

Les TPE peuvent aussi comprendre un grand nombre de blocs (plus de 30, typiquement de 50 à 500) plus petits, auquel cas ces blocs ont de préférence des masses peu élevées, par exemple de 500 à 5000 g/mol, ces TPE seront appelés TPE multiblocs par la suite, et sont un enchaînement blocs élastomères - blocs thermoplastiques.

Les blocs élastomères du TPE pour les besoins de l'invention, peuvent être tous les élastomères décrits précédemment pour l'élastomère diénique. Ils possèdent de préférence une Tg inférieure à 25°C, préférentiellement inférieure à 10°C, plus préférentiellement inférieure à 0°C et très préférentiellement inférieure à -10°C. De manière préférentielle également, la Tg bloc élastomère du TPE est supérieure à -100°C.

On utilisera pour la définition des blocs thermoplastiques la caractéristique de température de transition vitreuse (Tg) du bloc rigide thermoplastique. Cette caractéristique est bien connue de l'homme du métier. Elle permet notamment de choisir la température de mise en oeuvre industrielle (transformation). Dans le cas d'un polymère (ou d'un bloc de polymère) amorphe, la température de mise en oeuvre est choisie sensiblement supérieure à la Tg. Dans le cas spécifique d'un polymère (ou d'un bloc de polymère) semi-cristallin, on peut observer une température de fusion alors supérieure à la température de transition vitreuse. Dans ce cas, c'est plutôt la température de fusion (Tf) qui permet de choisir la température de mise en oeuvre du polymère (ou bloc de polymère) considéré. Ainsi, par la suite, lorsqu'on parlera de « Tg (ou Tf, le cas échéant) », il faudra considérer qu'il s'agit de la température utilisée pour choisir la température de mise oeuvre.

Pour les besoins de l'invention, les élastomères TPE comprennent un ou plusieurs bloc(s) thermoplastique(s) ayant de préférence une Tg (ou Tf, le cas échéant) supérieure ou égale à 80°C et constitué(s) à partir de monomères polymérisés. Préférentiellement, ce bloc thermoplastique a une Tg (ou Tf, le cas échéant) comprise dans un domaine variant de 80°C à 250°C. De préférence, la Tg (ou Tf, le cas échéant) de ce bloc thermoplastique est préférentiellement de 80°C à 200°C, plus préférentiellement de 80°C à 180°C.

La proportion des blocs thermoplastiques par rapport au TPE, tel que défini pour la mise en oeuvre de l'invention, est déterminée d'une part par les propriétés de thermoplasticité que doit présenter ledit copolymère. Les blocs thermoplastiques ayant une Tg (ou Tf, le cas échéant) supérieure ou égale à 80°C sont préférentiellement présents dans des proportions suffisantes pour préserver le caractère thermoplastique de l'élastomère selon l'invention. Le taux minimum de blocs thermoplastiques ayant une Tg (ou Tf, le cas échéant) supérieure ou égale à 80°C dans le TPE peut varier en fonction des conditions d'utilisation du copolymère. D'autre part, la capacité du TPE à se déformer lors de la préparation du pneu peut également contribuer à déterminer la proportion des blocs thermoplastiques ayant une Tg (ou Tf, le cas échéant) supérieure ou égale à 80°C.

Par exemple, le TPE est un copolymère dont la partie élastomère est saturée, et comportant des blocs styrènes et des blocs alkylènes. Les blocs alkylènes sont préférentiellement de l'éthylène, du propylène ou du butylène. Plus préférentiellement, cet élastomère TPE est choisi dans le groupe suivant, constitué de copolymères diblocs, triblocs linéaires ou étoilés : styrène/ éthylène/ butylène (SEB), styrène/ éthylène/ propylène (SEP), styrène/ éthylène/ éthylène/ propylène (SEEP), styrène/ éthylène/ butylène/ styrène (SEBS), styrène/ éthylène/ propylène/ styrène (SEPS), styrène/ éthylène/ éthylène/ propylène/ styrène (SEEPS), styrène/ isobutylène (SIB), styrène/ isobutylène/ styrène (SIBS) et les mélanges de ces copolymères.

Selon un autre exemple, le TPE est un copolymère dont la partie élastomère est insaturée, et qui comporte des blocs styrènes et des blocs diènes, ces blocs diènes étant en particulier des blocs isoprène ou butadiène. Plus préférentiellement, cet élastomère TPE est choisi dans le groupe suivant, constitué de copolymères diblocs, triblocs linéaires ou étoilés : styrène/ butadiène (SB), styrène/ isoprène (SI), styrène/ butadiène/ isoprène (SBI), styrène/ butadiène/ styrène (SBS), styrène/ isoprène/ styrène (SIS), styrène/ butadiène/ isoprène/ styrène (SBIS) et les mélanges de ces copolymères.

Par exemple également, le TPE est un copolymère linéaire ou étoilé dont la partie élastomère comporte une partie saturée et une partie insaturée comme par exemple le styrène/ butadiène/ butylène (SBB), le styrène/ butadiène/ butylène/ styrène (SBBS) ou un mélange de ces copolymères.

Parmi les TPE multiblocs, on peut citer les copolymères comportant des blocs copolymère statistique d'éthylène et de propylène/ polypropylène, polybutadiène/ polyuréthane (TPU), polyéther/ polyester (COPE), polyéther/ polyamide (PEBA).

Il est également possible que les TPE donnés en exemple ci-dessus soient mélangés entre eux au sein de la matrice TPE selon l'invention.

A titre d'exemples d'élastomères TPE commercialement disponibles, on peut citer les élastomères de type SEPS, SEEPS, ou SEBS commercialisés par la société Kraton sous la dénomination "Kraton G" (e.g. produits G1650, G1651, G1654, G1730) ou la société Kuraray sous la dénomination "Septon" (e.g. « Septon 2007 », « Septon 4033 », « Septon 8004 ») ; ou les élastomères de type SIS commercialisés par Kuraray, sous le nom « Hybrar 5125 », ou commercialisés par Kraton sous le nom de « D1161 » ou encore les élastomères de type SBS linéaire commercialisé par Polimeri Europa sous la dénomination « Europrene SOL T 166 » ou SBS étoilé commercialisés par Kraton sous la dénomination « D1184 ». On peut également citer les élastomères commercialisés par la société Dexco Polymers sous la dénomination de « Vector » ( e.g. « Vector 4114 », « Vector 8508 »). Parmi les TPE multiblocs, on peut citer le TPE « Vistamaxx » commercialisé par la société Exxon ; le TPE COPE commercialisé par la société DSM sous le dénomination « Arnitel », ou par la société Dupont sous le dénomination « Hytrel », ou par la société Ticona sous le dénomination « Riteflex » ; le TPE PEBA commercialisé par la société Arkema sous le dénomination « PEBAX » ; le TPE TPU commercialisé par la société Sartomer sous le dénomination « TPU 7840 », ou par la société BASF sous le dénomination « Elastogran ».

1.3 Système de réticulation

Le système de réticulation peut être tout type de système connu de l'homme de l'art dans le domaine des compositions de caoutchouc pour pneumatique. Il peut notamment être à base de soufre, et/ou de peroxyde et/ou de bismaléimides.

Selon un mode de réalisation préférentiel, le système de réticulation est à base de soufre, on parle alors d'un système de vulcanisation. Le soufre peut être apporté sous toute forme, notamment sous forme de soufre moléculaire, ou d'un agent donneur de soufre. Au moins un accélérateur de vulcanisation est également préférentiellement présent, et, de manière optionnelle, préférentielle également, on peut utiliser divers activateurs de vulcanisation connus tels qu'oxyde de zinc, acide stéarique ou composé équivalent tels que les sels d'acide stéarique et sels de métaux de transition, dérivés guanidiques (en particulier diphénylguanidine), ou encore des retardateurs de vulcanisation connus.

Lorsqu'il est présent, le soufre est utilisé à un taux préférentiel compris entre 0,5 et 12 pce, en particulier entre 1 et 10 pce. L'accélérateur de vulcanisation est utilisé à un taux préférentiel compris entre 0,5 et 10 pce, plus préférentiellement compris entre 0,5 et 5,0 pce.

On peut utiliser comme accélérateur tout composé susceptible d'agir comme accélérateur de vulcanisation des élastomères diéniques en présence de soufre, notamment des accélérateurs du type thiazoles ainsi que leurs dérivés, des accélérateurs de types sulfénamides, thiurames, dithiocarbamates, dithiophosphates, thiourées et xanthates. A titre d'exemples de tels accélérateurs, on peut citer notamment les composés suivants : disulfure de 2-mercaptobenzothiazyle (en abrégé "MBTS"), N-cyclohexyl-2-benzothiazyle sulfénamide ("CBS"), N,N-dicyclohexyl-2-benzothiazyle sulfénamide ("DCBS"), N-ter-butyl-2-benzothiazyle sulfénamide ("TBBS"), N-ter-butyl-2-benzothiazyle sulfénimide ("TBSI"), disulfure de tetrabenzylthiurame ("TBZTD"), dibenzyldithiocarbamate de zinc ("ZBEC") et les mélanges de ces composés.

Selon un autre mode de réalisation préférentiel, le système de réticulation contient préférentiellement un peroxyde. Avantageusement, le peroxyde est le seul agent de réticulation. Ainsi, avantageusement, selon ce mode de réalisation la composition ne comprend pas de système de vulcanisation, c'est-à-dire de système de réticulation à base de soufre.

Le peroxyde utilisable selon l'invention peut être tout peroxyde connu de l'homme de l'art. De manière préférée, le peroxyde est choisi parmi les peroxydes organiques.

Par « peroxyde organique », on entend un composé organique, c'est-à-dire contenant du carbone, comportant un groupe -O-O- (deux atomes d'oxygène liés par une liaison covalente simple).

Durant le procédé de réticulation, le peroxyde organique se décompose au niveau de sa liaison instable O-O en radicaux libres. Ces radicaux libres permettent la création des liaisons de réticulation.

Selon un mode de réalisation, le peroxyde organique est choisi dans le groupe constitué par les peroxydes de dialkyle, les monoperoxycarbonates, les peroxydes de diacyle, les peroxycétales, les peroxyesters, et leurs mélanges.

De préférence, les peroxydes de dialkyle sont choisis dans le groupe constitué par le peroxyde de dicumyle, le peroxyde de di-t-butyle, peroxyde de t-butylcumyle , le 2,5-diméthyl-2,5-di(t-butylperoxy)hexane , le 2,5-diméthyl-2,5-di(t-amylperoxy)-hexane, le 2,5-diméthyl-2,5-di(t-butylperoxy)hexyne-3, le 2,5-diméthyl-2,5-di(t-amylperoxy)hexyne-3, a,a'-di-[(t-butyl-peroxy)isopropyl] benzène, le a,a'-di-[(t-amyl-peroxy)isopropyl] benzène, le peroxyde de di-t-amyle , le 1,3,5-tri-[(t-butylperoxy)isopropyl]benzène, le 1,3-diméthyl-3-(t-butylperoxy)butanol, le 1,3-diméthyl-3-(t -amylperoxy) butanol, et leurs mélanges. Certains monoperoxycarbonates tels que le OO-tert-butyl-O-(2-éthylhexyl) monoperoxycarbonate, le OO-tert-butyl-O-isopropyl monoperoxycarbonate, le OO-tert-amyl-O-2-éthyl hexyl monoperoxycarbonate, et leurs mélanges, peuvent également être utilisés.

Parmi les peroxydes de diacyles, le peroxyde préféré est le peroxyde de benzoyle.

Parmi les peroxycétales, les peroxydes préférés sont choisis dans le groupe constitué par le 1,1-di-(t-butylperoxy)-3,3,5-triméthylcyclohexane, le 4,4-di-(t-butylperoxy)valérate de n-butyle, le 3,3-di-(t-butylperoxy)butyrate d'éthyle, le 2,2-di-(t-amylperoxy)-propane, le 3,6,9-triethyl-3,6,9-trimethyl-1,4,7-triperoxynonane (ou peroxyde de méthyl éthyl cétone trimère cyclique), le 3,3,5,7,7-pentamethyl-1,2,4-trioxepane, le 4,4-bis(t-amylperoxy)valérate de n-butyle, le 3,3-di(t-amylperoxy)butyrate d'éthyle, le 1,1-di(t-butylperoxy)cyclohexane, le 1,1-di(t-amylperoxy)cyclohexane, et leurs mélanges.

De préférence, les peroxyesters sont choisis dans le groupe constitué par le tert-butylperoxybenzoate, le tert-butyleperoxy-2-ethylhexanoate, le tert-butyleperoxy-3,5,5-triméthylehexanoate et leurs mélanges.

De manière particulièrement préférée, le peroxyde organique est choisi dans le groupe constitué par le peroxyde de dicumyle, les peroxydes d'aryle ou de diaryle, le peroxyde de diacétyle, le peroxyde de benzoyle, le peroxyde de dibenzoyle, le peroxyde de ditertbutyle, le peroxyde de tertbutylcumyle, le 2,5-bis (tertbutylperoxy)-2,5-diméthylhexane, le n-butyl-4,4'-di(tert-butylperoxy) valérate, le OO-(t-butyl)-O-(2-éthylhexyl) monoperoxycarbonate, le tertio-butyl peroxyisopropylcarbonate, le tertio-butyl peroxybenzoate, le tert-butyl peroxy-3,5,5-triméthylhexanoate, le 1,3(4)-bis(tert-butylperoxyisopropyl)benzene et les mélanges de ces derniers, encore préférentiellement dans le groupe consistant en le peroxyde de dicumyle, le n-butyl-4,4'-di(tert-butylperoxy)-valérate, le OO-(t-butyl) O-(2-éthylhexyl) monoperoxycarbonate, le tertio-butyl peroxyisopropylcarbonate, le tertio-butyl peroxybenzoate, le tert-butyl peroxy-3,5,5-triméthylhexanoate, le 1,3(4)-bis(tert-butylperoxyisopropyl)benzene et les mélanges de ces derniers.

Lorsqu'il est présent, le taux total de peroxyde dans la composition est de préférence supérieur ou égal à 0,3 pce, plus préférentiellement supérieur ou égal à 0,75 pce, de préférence compris dans un domaine allant de 0,5 à 5 pce, en particulier de 0,5 à 3 pce.

### 1.4 Charges inorganiques piézoélectriques

Les charges inorganiques piézoélectriques sont avantageusement dispersées dans la composition de caoutchouc.

Avantageusement, les charges inorganiques piézoélectriques sont sous forme de particules non liées à l'élastomère diénique.

Les charges inorganiques piézoélectriques comprennent des composés piézoélectriques inorganiques. Il peut s'agir de monocristaux piézoélectriques ou de céramiques piézoélectriques.

Les monocristaux piézoélectriques sont notamment des matériaux piézoélectriques naturels comme le quartz ou la tourmaline. Les cristaux ferroélectriques peuvent posséder une structure en domaines. On peut distinguer les monocristaux monodomaines et polydomaines selon qu'une ou plusieurs directions de polarisation coexistent dans le cristal.

Les céramiques sont des matériaux piézoélectriques à fort couplage électromécanique et haute densité. Les céramiques tirent leur propriété piézoélectrique de leur structure cristalline, à travers l'absence de symétrie de la maille cristalline qui dissocie les centres de gravité des charges positives et négatives, chaque maille constituant alors un dipôle électrique. La maille cristalline possède ainsi un dipôle permanent qui confère à ces matériaux des valeurs de permittivité diélectrique élevées. Les céramiques de synthèse sont en particulier composées d'oxydes ferroélectriques, qui ont pour propriété de posséder une polarisation électrique à l'état spontané, qui peut en outre être renversée par l'application d'un champ électrique extérieur suffisamment intense.

Avantageusement les charges inorganiques piézoélectriques sont des céramiques piézoélectriques.

Avantageusement, les charges inorganiques piézoélectriques sont des oxydes ferroélectriques.

Les oxydes ferroélectriques peuvent notamment être dotés d'une structure pérovskite. Ils répondent avantageusement à une formule générale $ABO_3$ tels que le titanate de baryum ($BaTiO_3$), le titanate de plomb ($PbTiO_3$), le niobate de potassium ($KNbO_3$), le niobate de plomb ($PbNbO_3$), ou le ferrite de bismuth ($BiFeO_3$). Dans cette famille de matériaux piézoélectriques, on peut également citer le titano-zirconate de plomb (PZT) avec une structure $Pb(Zr_xTi_{1-x})O_3$ dans laquelle x est compris entre 0 et 1. Il peut être sous forme pure ou sous forme de semi-conducteur dopé soit avec des dopants accepteurs (pour donner un PZT dit dur ou hard), tels que Fe, Co, Mn, Mg, Al, In, Cr, Sc, Na ou K, soit avec des dopants donneurs (pour donner un PZT dit doux ou soft), tels que La, Nd, Sb, Ta, Nb ou W.

A titre d'exemples non limitatifs, les charges inorganiques piézoélectriques peuvent être choisies dans le groupe comprenant du titanate de baryum, titanate de plomb, titano-zirconate de plomb (PZT), niobate de plomb, niobate de lithium et niobate de potassium, avantageusement les charges inorganiques piézoélectriques sont des charges de titanate de baryum.

Le titanate de baryum, tout comme le niobate de potassium sont des matériaux piézoélectriques sans plomb. Ils ont l'avantage d'être moins toxiques.

Les céramiques piézoélectriques les plus connues sont le titanate de baryum ($BaTiO_3$) et le titanate zirconate de plomb (PZT), qui ont un très bon coefficient électromécanique et présentent des procédés de fabrication variés. Ces derniers (procédé sol-gel, synthèse hydrothermale, calcination, ...) permettent de modifier les propriétés diélectrique, mécanique et piézoélectrique en fonction de l'application visée.

Les charges ont avantageusement la forme de particules. En particulier, les charges ont des tailles de particules comprises entre 50 nm et 500 $\mu$m. La taille des particules correspond au diamètre moyen des particules. La mesure du diamètre moyen est réalisée par analyse microscopique électronique à balayage (MEB). Des clichés sont réalisés sur des échantillons de poudre. Une analyse d'image est réalisée à l'aide d'un logiciel et permet d'accéder au diamètre moyen des particules présentes.

La température de Curie, Tc, d'un matériau piézoélectrique correspond à la température à laquelle le matériau devient paraélectrique. Ainsi, le cycle d'hystérésis caractéristique du matériau piézoélectrique, et qui est obtenu par le tracé de la polarisation en fonction du champ électrique appliqué au matériau, disparaît lorsque la température de Curie est atteinte. La température de Curie est caractéristique du matériau piézoélectrique.

Le taux de charge des charges inorganiques piézoélectriques est d'au moins 5% en volume par rapport au volume total de la composition de caoutchouc.

En particulier, le taux de charges inorganiques piézoélectriques varie de 5% à 80% de volume par rapport au volume total de la composition de caoutchouc, avantageusement de 5% à 60%, plus avantageusement encore de 5% à 50%. Le taux de charges inorganiques piézoélectriques est d'au moins 5% de volume, en particulier au moins 6% de volume, voire 7% de volume par rapport au volume total de la composition de caoutchouc.

Avantageusement, la couche P est de connectivité 0-3, comprenant des particules de charges piézoélectriques dispersées dans l'élastomère diénique. La connectivité dépend de l'organisation spatiale de chaque phase constitutive du matériau composite. Un changement de connectivité entraîne des modifications majeures des propriétés physiques des composites. Dans le cas de systèmes bi-phasiques, la nature de la connectivité est représentée par deux nombres (le premier pour la céramique, le second pour la matrice). Ils indiquent le nombre de directions connectées par la phase considérée. Ainsi, un composite de connectivité 0-3 correspond à un composite constitué par des grains de poudre piézoélectrique dispersées dans l'élastomère diénique. Le principal avantage de ce type de composite est la facilité de la mise en oeuvre du procédé, ou encore la facilité de réaliser des formes complexes, telles que des surfaces incurvées.

### 1.5 - Autres additifs

La composition de caoutchouc de la couche P selon l'invention comporte optionnellement également tout ou partie des additifs usuels habituellement utilisés dans les compositions d'élastomères destinées notamment à la fabrication de pneumatiques, comme par exemple des pigments, des agents de protection tels que cires anti-ozone, anti-ozonants chimiques, anti-oxydants, des agents plastifiants tels que les huiles plastifiantes ou les résines hydrocarbonées bien connues de l'homme de l'art, des résines renforçantes, des accepteurs (par exemple résine phénolique novolaque) ou des donneurs de méthylène (par exemple HMT ou H3M).

Avantageusement la couche P ne comprend pas de charges conductrices. Dans le cas où des charges conductrices seraient également présentes dans cette couche P, le taux de charges conductrices est avantageusement inférieur à 5% de volume par rapport au volume total de la composition de caoutchouc, plus avantageusement inférieur à 1% de volume par rapport au volume total de la composition de caoutchouc. Dans le cas où des charges conductrices seraient également présentes dans cette couche P, le taux de charges conductrices est avantageusement inférieur à 0,3 pce.

### 2. Composition de caoutchouc de la couche E

Chaque couche E est une composition de caoutchouc à base :

- d'au moins 50 pce d'élastomère diénique,
- d'un système de réticulation,
- de charges conductrices.

### 2.1 Elastomère diénique

L'élastomère diénique de chaque couche E répond à la même définition que celle donnée précédemment pour l'élastomère diénique de la couche P.

Les élastomères diéniques de chaque couche E peuvent être identiques ou différents, ils sont avantageusement identiques. En outre, les élastomères diéniques de chaque couche E et de la couche P peuvent être identiques ou différents, ils sont avantageusement identiques.

La composition de caoutchouc formant chaque couche E peut contenir un seul élastomère diénique ou un mélange de plusieurs élastomères diéniques.

Si d'éventuels autres élastomères sont utilisés dans la composition de caoutchouc, le ou les élastomères diéniques constituent la fraction majoritaire en poids ; ils représentent alors plus de 50% en poids, plus préférentiellement au moins 75% en poids par rapport au poids total des élastomères dans la composition de caoutchouc. De manière préférentielle également, le ou les élastomères diéniques représentent au moins 90%, voire 95% (en particulier 100%) en poids par rapport au poids total des élastomères dans la composition de caoutchouc.

L'élastomère diénique est l'élastomère majoritaire en poids de la composition de caoutchouc. Ainsi, la composition de caoutchouc comprend plus de 50 pce d'élastomère diénique, et ainsi de plus de 50 pce à 100 pce d'élastomère diénique, avantageusement de 75 pce à 100 pce, plus avantageusement de 90 pce à 100 pce, encore plus avantageusement de 95 pce à 100 pce, d'élastomère diénique.

Dans une variante préférée de l'invention, l'élastomère diénique, ou le mélange d'élastomères diéniques, est le seul élastomère de la composition de caoutchouc (correspondant ainsi à 100 pce).

### 2.2 Autre élastomère

Dans une autre variante de l'invention, la composition de caoutchouc peut comprendre un autre élastomère, en une teneur strictement inférieure à 50 pce.

Cet autre élastomère peut en particulier être un élastomère thermoplastique (en abrégé « TPE »).

### 2.2.1 Élastomère thermoplastique

L'élastomère thermoplastique de chaque couche E répond à la même définition que celle donnée précédemment pour l'élastomère diénique de la couche P.

Les élastomères thermoplastiques de chaque couche E peuvent être identiques ou différents, ils sont avantageusement identiques. En outre, les élastomères thermoplastiques de chaque couche E et de la couche P peuvent être identiques ou différents, ils sont avantageusement identiques.

### 2.3 Système de réticulation

Le système de réticulation de la composition de caoutchouc de l'invention pour chaque couche E peut être tout type de système connu de l'homme de l'art dans le domaine des compositions de caoutchouc pour pneumatique. Il peut notamment être à base de soufre, et/ou de peroxyde et/ou de bismaléimides.

Selon un mode de réalisation préférentiel, dans une ou chaque couche E, le système de réticulation est à base de soufre. Ce système de vulcanisation peut être tel que décrit précédemment pour la composition de caoutchouc de la couche P .

Lorsqu'il est présent, le soufre est utilisé à un taux préférentiel compris entre 0,5 et 12 pce, en particulier entre 1 et 10 pce. L'accélérateur de vulcanisation est utilisé à un taux préférentiel compris entre 0,5 et 10 pce, plus préférentiellement compris entre 0,5 et 5,0 pce.

Tel que décrit précédemment, le système de réticulation peut également comprendre un accélérateur.

Selon un autre mode de réalisation préférentiel, dans une ou chaque couche E, le système de réticulation contient préférentiellement un peroxyde. Avantageusement, le peroxyde est le seul agent de réticulation. Ainsi, avantageusement, selon ce mode de réalisation la composition ne comprend pas de système de vulcanisation, c'est-à-dire de système de réticulation à base de soufre.

Lorsqu'il est présent, le taux total de peroxyde dans la composition est de préférence supérieur ou égal à 0,3 pce, plus préférentiellement supérieur ou égal à 0,75 pce, de préférence compris dans un domaine allant de 0,5 à 5 pce, en particulier de 0,5 à 3 pce.

Le peroxyde utilisable selon l'invention est avantageusement tel que décrit précédemment pour la composition de caoutchouc de la couche P.

Les systèmes de réticulation de chaque couche E peuvent être identiques ou différents, ils sont avantageusement identiques. En outre, les systèmes de réticulation des compositions de caoutchouc de chaque couche E et de la couche P peuvent être identiques ou différents, ils sont avantageusement identiques.

### 2.4 Charges conductrices

Les charges conductrices sont avantageusement dispersées dans la composition de caoutchouc.

De manière connue de l'homme de l'art, une charge conductrice est un composé qui introduit dans un milieu, en présence d'un courant électrique, entraine l'apparition d'un courant électrique dans le milieu.

La charge conductrice est un noir de carbone graphité ou partiellement graphité également dits noirs conducteurs. Ces noirs conducteurs sont par exemple commercialisées par la société Timcal sous le nom commercial « ENSACO 350G », de surface spécifique (BET mesurée selon la norme ASTM D3037) de 770 $m^2/g$, ou « ENSACO 260G », de surface spécifique de 70 $m^2/g$. De manière très préférentielle, la charge conductrice est un noir de carbone graphité ou conducteur électrique de surface spécifique (BET mesurée par la norme ASTM D3037) supérieure à 65 $m^2/g$, plus préférentiellement supérieure à 100 $m^2/g$ et très préférentiellement supérieure à 500 $m^2/g$.

La quantité de charge conductrice dans la composition de caoutchouc de chaque couche E de l'invention est préférentiellement comprise dans un domaine allant de 10% à 40% en volume, de préférence de 15 à 30% en volume Ces taux volumiques préférentiels correspondent environ à des taux en pce, également préférentiels, compris dans un domaine allant de 20 à 50 pce, de préférence de 20 à 40 pce et plus préférentiellement de 25 à 40 pce.

A titre d'exemples pour Noirs conducteurs, on peut notamment citer le noir de carbone conducteur « ENSACO 260 G » de la société Timcal ou le noir de carbone conducteur « ENSACO 350 G » de la société Timcal.

La taille des charges conductrices varie avantageusement de 50 nm à 500 $\mu$m.

### 2.5 Autres additifs

La composition de caoutchouc de chaque couche E selon l'invention comporte optionnellement également tout ou partie des additifs usuels habituellement utilisés dans les compositions d'élastomères destinées notamment à la fabrication de pneumatiques, comme par exemple des pigments, des agents de protection tels que cires anti-ozone, anti-ozonants chimiques, anti-oxydants, des agents plastifiants tels que les huiles plastifiantes ou les résines hydrocarbonées bien connues de l'homme de l'art, des résines renforçantes, des accepteurs (par exemple résine phénolique novolaque) ou des donneurs de méthylène (par exemple HMT ou H3M).

Avantageusement chaque couche E ne comprend pas de charges inorganiques piézoélectriques. Dans le cas où des charges inorganiques piézoélectriques seraient également présentes dans une couche E, le taux de charges inorganiques piézoélectriques est avantageusement inférieur à 5% de volume par rapport au volume total de la composition de caoutchouc, plus avantageusement inférieur à 1% de volume par rapport au volume total de la composition de caoutchouc.

Chaque couche E forme une électrode.

Les électrodes sont déposées sur les faces du composite piézoélectrique, formant la couche P, selon l'invention afin de collecter les charges émises par ledit composite.

Le dispositif selon l'invention est avantageusement relié à un organe électronique afin de capter les impulsions électriques émises et d'utiliser cette information.

3. Dispositif selon l'invention

Selon l'invention, l'élastomère diénique de la couche P est co-réticulé avec l'élastomère diénique de chaque couche E. Ainsi, les différentes couches sont avantageusement liées entre-elles de manières covalentes permettant d'obtenir un dispositif qui est cohésif.

4. Procédé de préparation

4.1 Polarisation

L'invention a également pour objet un procédé de préparation d'un dispositif selon l'invention polarisé comprenant une étape de polarisation, ici dénommée (a4), d'un dispositif tel que décrit précédemment.

L'étape de polarisation du dispositif correspond à l'application d'un champ électrique aux bornes du dispositif électroactif pour orienter les dipôles des charges piézoélectriques dans la même direction afin d'obtenir une polarisation macroscopique du dispositif.

La polarisation dépend de la température de polarisation, du champ électrique appliqué et du temps de polarisation.

Avantageusement, la température de polarisation est au moins inférieure de 5°C par rapport à la température de Curie, Tc, la plus faible des charges inorganiques piézoélectriques, plus avantageusement au moins 7°C de moins, encore plus avantageusement au moins 10°C de moins que la température de Curie, Tc, la plus faible des charges inorganiques piézoélectriques. En effet, proche de la température de Curie des charges inorganiques piézoélectriques, l'agitation des dipôles rend plus difficile leur alignement sous un champ électrique.

En particulier, le champ électrique appliqué lors de l'étape de polarisation est compris entre 0,5 et 8kV/mm, avantageusement entre 0,75 et 4kV/mm.

En particulier le champ électrique appliqué dépend de la nature de la charge piézoélectrique et de la durée de polarisation du composite piézoélectrique. L'homme du métier sait adapter le champ électrique à la charge piézoélectrique et à la durée de polarisation.

En particulier, la durée de polarisation est comprise entre 1 minute et 10 heures, de préférence entre 5 minutes et 2 heures.

Le dispositif pourra être polarisé après fabrication, avant intégration au pneumatique. En particulier, le dispositif selon l'invention pourra être fabriqué ; puis découpé aux dimensions voulues et polarisé, ces deux étapes pouvant être réalisées dans n'importe quel ordre, et ainsi on pourra découper aux dimensions voulues puis polariser ou polariser puis découper aux dimensions voulues ; et enfin collé au pneumatique. Le dispositif sera avantageusement collé dans la paroi interne d'un pneumatique, tel que décrit par la suite. Alternativement, le dispositif selon l'invention pourra être polarisé après son intégration dans un pneumatique. Avantageusement, dans une telle option, le pneumatique est encore à l'état cru, c'est-à-dire que le dispositif est intégré au pneumatique avant cuisson dudit pneumatique.

4.2 Fabrication du dispositif

L'invention a également pour objet un procédé de préparation d'un dispositif selon l'invention comprenant les étapes suivantes :

(a1) Placer au moins une couche P composite piézoélectrique entre deux couches E, identiques ou différentes, composites conductrices pour obtenir un assemblage ;
(a2) Appliquer une pression sur l'assemblage obtenu suite à l'étape (a1) ;
(a3) Réticuler l'assemblage pour obtenir le dispositif selon l'invention.

Lors de l'étape (a1), les couches sont avantageusement successivement déposées dans un moule adapté, appelé moule de cuisson, qui peut avoir toute dimension.

Lors de l'étape (a2), une pression allant de 1 000 000 à 3 000 000 Pa, avantageusement allant de 1 600 000 à 2 400 000 Pa, est appliquée à l'assemblage. La durée de la compression est adaptée en fonction de la pression choisie ; elle peut par exemple durer de 5 min à 90 min.

L'étape (a3) est réalisée par cuisson, c'est-à-dire en chauffant l'assemblage à une température généralement comprise entre 130°C et 200°C, pendant un temps suffisant qui peut varier par exemple entre 5 et 90 min en fonction notamment de la température de cuisson, du système de réticulation adopté et de la cinétique de réticulation de la composition considérée.

Les étapes (a2) et (a3) peuvent être simultanées. Par exemple, lorsque les couches sont déposées dans un moule de cuisson, ce moule peut être déposé dans une presse à plateaux où l'assemblage va être cuit sous pression.

Les compositions de caoutchouc de la couche P et de chaque couche E sont fabriquées dans des mélangeurs appropriés, en utilisant par exemple deux phases de préparation successives selon une procédure générale bien connue de l'homme du métier : une première phase de travail ou malaxage thermomécanique (parfois qualifiée de phase "non-productive") à haute température, jusqu'à une température maximale comprise entre 80°C et 190°C, de préférence entre 80°C et 150°C, suivie d'une seconde phase de travail mécanique (parfois qualifiée de phase "productive") à plus basse température, typiquement inférieure à 80°C, par exemple entre 60°C et 80°C, phase de finition au cours de laquelle est incorporé le système de réticulation.

Un procédé utilisable pour la fabrication de telles compositions de caoutchouc comporte par exemple et de préférence les étapes suivantes :

- dans un mélangeur, incorporer à l'élastomère diénique et la charge et les éventuels autres ingrédients de la composition à l'exception du système de réticulation, en malaxant thermomécaniquement le tout, en une ou plusieurs fois, jusqu'à atteindre une température maximale comprise entre 80°C et 190°C ;
- refroidir l'ensemble à une température inférieure à 80°C ;
- incorporer ensuite le système de réticulation ;
- malaxer le tout jusqu'à une température maximale inférieure à 80°C ;
- extruder ou calandrer la composition de caoutchouc ainsi obtenue.

A titre d'exemple, la première phase (non-productive) est conduite en une seule étape thermomécanique au cours de laquelle on introduit, dans un mélangeur approprié tel qu'un mélangeur interne usuel, tous les constituants nécessaires, les additifs divers, à l'exception du système de réticulation. Après refroidissement du mélange ainsi obtenu au cours de la première phase non-productive, on incorpore alors le système de réticulation à basse température, généralement dans un mélangeur externe tel qu'un mélangeur à cylindres ; le tout est alors mélangé (phase productive) pendant quelques minutes, par exemple entre 5 et 15 min.

La composition finale ainsi obtenue peut ensuite être calandrée, par exemple sous la forme d'une feuille, d'une plaque ou encore extrudée, par exemple pour former un profilé de caoutchouc.

La couche P composite piézoélectrique est avantageusement préparée par un procédé comprenant les étapes suivantes :

(b1) incorporer à un élastomère diénique, dans un mélangeur, une charge inorganique piézoélectrique en malaxant thermomécaniquement le tout, en une ou plusieurs fois, jusqu'à atteindre une température maximale comprise entre 80°C et 190°C, puis
(b2) refroidir l'ensemble à une température inférieure à 80°C ;
(b3) incorporer ensuite un système de réticulation ;
(b4) malaxer le tout jusqu'à une température maximale inférieure à 80°C ;
(b5) calandrer ou extruder la composition de caoutchouc ainsi obtenue sous la forme d'une bande.

Chaque couche E composite conducteur est avantageusement préparée par un procédé comprenant les étapes suivantes :

(c1) incorporer à un élastomère diénique, dans un mélangeur, une charge conductrice en malaxant thermomécaniquement le tout, en une ou plusieurs fois, jusqu'à atteindre une température maximale comprise entre 80°C et 190°C ;

(c2) refroidir l'ensemble à une température inférieure à 80°C ;

(c3) incorporer ensuite un système de réticulation ;

(c4) malaxer le tout jusqu'à une température maximale inférieure à 80°C ;

(c5) calandrer ou extruder la composition de caoutchouc ainsi obtenue sous la forme d'une bande.

Le procédé de préparation comprend avantageusement une étape de polarisation (a4) du dispositif obtenu suite à l'étape (a3), avantageusement à une température de polarisation inférieure d'au moins 5°C à la température de Curie, Tc, la plus faible des charges inorganiques piézoélectriques. Cette étape de polarisation (a4) est avantageusement telle que décrite précédemment.

## 5. Pneumatique comprenant un dispositif selon l'invention

L'invention a également pour objet un pneumatique comprenant un dispositif selon l'invention.

Le pneumatique est avantageusement un pneumatique à armature de carcasse radiale notamment destiné à équiper des véhicules tourisme ou des véhicules poids lourd.

Le dispositif selon l'invention peut être utilisée dans différentes parties du pneumatique, notamment dans le sommet, et la zone du flanc.

*Architecture générale du pneumatique*

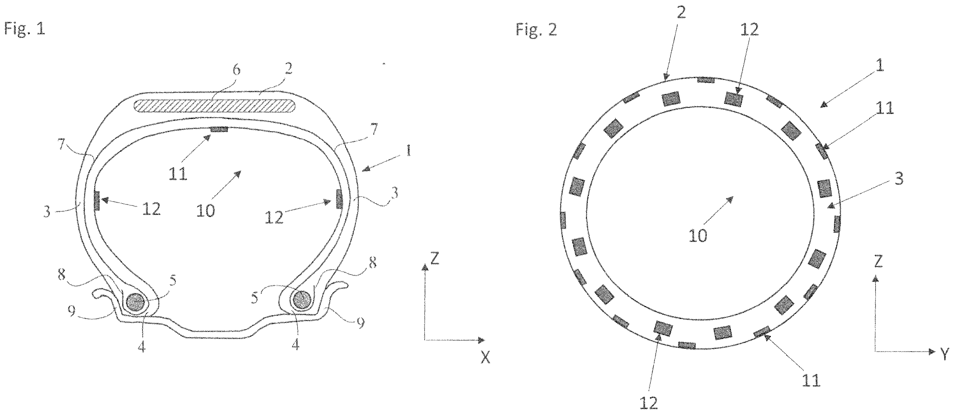

En référence aux figures 1 et 2, l'invention concerne un pneumatique 1.

Le pneumatique 1 comporte un sommet 2 renforcé par une armature de sommet ou ceinture 6, deux flancs 3 et deux bourrelets 4, chacun de ces bourrelets 4 étant renforcé avec une tringle 5. Le sommet 2 est surmonté d'une bande de roulement non représentée sur cette figure schématique. Une armature de carcasse 7 est enroulée autour des deux tringles 5 dans chaque bourrelet 4, le retournement 8 de cette armature 7 étant par exemple disposé vers l'extérieur du pneumatique 1 qui est ici représenté monté sur sa jante 9. L'armature de carcasse 7 est de manière connue en soi constituée d'au moins une nappe renforcée par des câbles dits "radiaux", c'est-à-dire que ces câbles sont disposés pratiquement parallèles les uns aux autres et s'étendent d'un bourrelet à l'autre de manière à former un angle compris entre 80° et 90° avec le plan circonférentiel médian (plan perpendiculaire à l'axe de rotation du pneumatique qui est situé à mi-distance des deux bourrelets 4 et passe par le milieu de l'armature de sommet 6). Le sommet 2 et les flancs 3 définissent une cavité 10 interne, en vis-à-vis d'une jante lorsque le pneumatique 1 est monté sous forme de roue. Cette cavité est destinée à être gonflée d'air. On note que cette cavité définit une paroi interne du pneumatique 1, par opposition à une paroi externe destinée à être, en ce qui concerne le sommet 2, en contact avec la route.

On définit un repère du pneumatique 1 comprenant un axe de révolution X (correspondant à un axe de révolution du pneumatique 1) orienté arbitrairement (en supposera que le pneumatique 1 est symétrique selon ledit axe de révolution X), un axe radial Z orthogonal à l'axe longitudinal X définissant une direction radiale orientée du centre vers la périphérie du pneumatique 1, et un axe azimutal Y (i.e. tangentiel, c'est-à-dire orthogonal à la fois à l'axe radial Z et à l'axe longitudinal X) orienté arbitrairement selon la direction de roulement du pneumatique 1. Ainsi, en parcourant le pneumatique 1 selon ladite direction radiale, on rencontre successivement la paroi interne, les éléments constitutifs du pneumatique 1, puis la paroi externe.

Tel que représenté sur les figures 1 et 2, le pneumatique 1 comprend avantageusement au moins un insert 11, 12, et avantageusement une pluralité d'inserts 11 et 12, chaque insert 11, 12 comprenant le dispositif selon l'invention.

Selon un mode de réalisation, non représentée sur les figures, chaque insert 11, 12 s'étend le long d'un des flancs 3 ou du sommet 2 ou le long d'un flanc 3 jusqu'à l'autre flanc 3 en passant par le sommet 2, *i.e.* les inserts 11, 12 peuvent être confondus et s'étendent sur toute une région qui peut être aussi étendue que la surface totale du sommet et/ou des flancs.

Selon un autre mode de réalisation, chaque insert 11, 12 s'étend de façon limitée le long d'un des flancs 3 ou du sommet 2. i. e. les inserts 11, 12 sont localisés, de sorte que chaque insert 11, 12 s'étend sur une région précise, plus restreinte que la surface totale du sommet et/ou des flancs. En d'autres termes, l'insert 11, 12 est localisé à une position prédéterminée (le long du sommet 2 ou du flanc 3). Cette disposition technique permet de détecter la localisation d'un choc.

Selon une première disposition de cet autre mode de réalisation, ici présentée, le pneumatique 1 comprend une série de premiers inserts 11 s'étendant le long du sommet 2. Les premiers inserts 11 sont préférentiellement répartis selon un intervalle le long du sommet 2. Ledit intervalle est choisi préférentiellement d'une longueur telle qu'entre deux premiers inserts 11 successifs on trouve une zone du sommet 2 dépourvue d'insert 11. Les premiers inserts 11 sont positionnés chacun dans un plan azimutal perpendiculaire à l'axe radial Z et coïncidant avec l'axe longitudinal X et l'axe azimutal Y. Les premiers inserts 11 visent à détecter l'usure du sommet 2 et surtout à détecter un choc radial sur le pneumatique 1, par exemple en roulant sur un nid de poule. Du fait de la pluralité de premiers inserts, on peut facilement retrouver quelle zone du sommet 2 a subi le choc, et s'assurer que le pneumatique 1 n'y présente pas de dégradation.

Selon une autre disposition de cet autre mode de réalisation, non représentée, le pneumatique 1 peut comprendre un unique premier insert 11, ce qui permet, outre la mesure de l'usure du pneumatique 1, de détecter chaque tour du pneumatique (en effet, à chaque détection de force, c'est que la zone du sommet 2 en vis-à-vis dudit unique premier insert 11 est en contact du sol).

Selon une variante de la première disposition de cet autre mode de réalisation, ici présentée, le pneumatique 1 comprend en outre une série de deuxièmes inserts 12 s'étendant le long d'un ou des deux flancs 3. En cas d'une pluralité de deuxièmes inserts 12, ces derniers sont disposés chacun dans des secteurs angulaires différents du flanc 3, et de manière préférée sont répartis selon un intervalle le long de chaque flanc 3. Similairement à ce qui est proposé pour les premiers inserts 11, ledit intervalle est choisi préférentiellement d'une longueur telle qu'entre deux deuxièmes inserts 12 successifs on trouve une zone du flanc 3 dépourvue d'insert 12. Les deuxièmes inserts 12 sont positionnés chacun substantiellement dans un plan médian perpendiculaire à l'axe longitudinal X et coïncidant avec l'axe radial Z et l'axe azimutal Y, même si l'on comprendra que du fait du caractère bombé du pneumatique 1 lorsqu'il est gonflé, l'orientation des deuxièmes inserts 12 peut légèrement s'écarter du plan médian.

Les deuxièmes inserts 12 permettent de détecter un choc latéral sur le pneumatique 1, par exemple le heurt d'un trottoir. Du fait de la disposition dans des secteurs angulaires différents du flanc 3, on peut facilement retrouver quel secteur angulaire a subi le choc, et s'assurer que le pneumatique 1 n'y présente pas de dégradation.

Dans tous ces modes de réalisation, on comprendra que les termes « premier » et « deuxième » désignant les inserts 11 ou 12 sont seulement relatifs à leur position et qu'en pratique les premiers et deuxièmes inserts 11, 12 sont préférentiellement structurellement identiques. Par ailleurs, la présente invention pourra comprendre des premiers insert 11 et/ou des deuxièmes inserts 12, l'invention n'étant limitée à aucune configuration.

Selon une disposition particulière les inserts 11 et/ou 12 peuvent être collés dans la cavité sur la paroi interne, respectivement contre le sommet 2 et/ou les flancs 3.

Selon une autre disposition particulière, les inserts 11 et/ou 12 peuvent être noyés dans la masse d'un matériau formant le sommet 2 et/ou les flancs 3.

Selon une autre disposition particulière, le pneumatique 1 peut comprendre successivement selon la direction radiale, une couche intérieure et une couche extérieure. La couche extérieure peut présenter au niveau du sommet 2 une bande de roulement destinée à être en contact avec la chaussée et la couche intérieure étant positionnée en sous-face de la couche extérieure. Les inserts 11 et/ou 12 peuvent être positionnés dans la couche intérieure et/ou dans une région d'interface de la couche intérieure et de la couche extérieure.

Selon une autre disposition particulière, les inserts 11 et/ou 12 peuvent être collés à l'armature de carcasse 7.

On comprendra que la présente invention n'est pas limitée à une de ces dispositions particulières, et qu'il est possible de les combiner, par exemple en disposant le ou les premiers inserts 11 dans la masse du matériau formant le sommet 2, tout en collant le ou les deuxièmes inserts 12 à la paroi interne d'un flanc 3.

Dans le mode de réalisation où l'insert 11, 12 comprenant le dispositif est adhéré à un pneumatique cuit, ou réticulé, la fixation peut être réalisée par des moyens classiques connus de l'homme de l'art comme le grattage du badigeon, l'utilisation de réticulation à froid ou encore la fusion. La fixation peut se faire par collage par adhésif.

En particulier, l'insert, et ainsi le dispositif selon l'invention, peut être adhéré au pneumatique via une bande adhésive.

La bande adhésive utilisée comme zone de fixation sur l'organe ou comme partie adhésive sur le pneumatique, peut être tout type de bande adhésive connue, parfois appelée « scotch » (« tape » en anglais) ou encore PSA (« Pressure Sensitive Adhesive »).

Comme connu de l'homme de l'art des adhésifs, l'appellation « Pressure Sensitive Adhesive » est utilisée pour désigner des matériaux qui sont intrinsèquement collants ou qui ont été rendus collants par l'addition de résines tackifiantes. Plusieurs méthodes permettent d'identifier un PSA, notamment les trois suivantes :

- un PSA peut être décrit par les critères de Dahlquist du point de vue mécanique et viscoélastique,
- un PSA est un matériau qui possède du collant (ou « tack ») de façon permanente et agressive à température ambiante et adhère fortement à diverses surfaces par simple contact sans besoin de pression supérieur à celle applicable à la main,
- un PSA est un matériau dont le module de conservation est compris entre 0,02 MPa et 0,04 MPa à une fréquence de 0.1 radis (0,017Hz) et 0,2 MPa à 0,8 MPa à une fréquence de 100 radis (17Hz).

De manière préférentielle pour l'invention, on utilise comme bande adhésive un PSA dit « acrylique », connu de l'homme de l'art (« Technology of Pressure Sensitive Adhesives and Products », de I.Benedek et M.F.Feldstein, chapitre 5 « Acrylic adhesives » de P.B.Foreman) comprenant 50 à 100% en masse de monomères dits « primaires ». Ces monomères sont des esters d'acide acrylique obtenus avec des alcools primaires ou secondaires dont les parties alkyl sont en $C_4$-$C_{20}$, et de préférence ces monomères sont choisis dans le groupe constitué par le 2-éthylhexylacrylate, l'iso-octyl acrylate, le n-butyl acrylate et leurs mélanges. Ces monomères primaires présentent une Tg basse, de préférence inférieure à 0°C, conférant le caractère mou et de pégosité (tack) de la bande adhésive. Optionnellement, la composition acrylique comprend de 0 à 35 % en masse de monomères dits « secondaires », de Tg supérieure à 0°C qui sont connus de l'homme de l'art et préférentiellement choisis dans le groupe constitué par le méthyl acrylate, le méthyl méthacrylate, l'acétate de vinyle, le styrène et leurs mélanges. Plus préférentiellement, on utilise le méthyl acrylate. Ces monomères secondaires permettent d'améliorer la cohésion de la masse adhésive. Ils ont pour effet d'augmenter le module et la Tg. A titre optionnel, la composition acrylique comprend de 0 à 15% de monomères polaires et fonctionnels, qui peuvent être de tout type autre que les monomères primaires et secondaires précédemment décrits. De manière préférentielle, ces monomères sont choisis dans le groupe constitué par l'acide acrylique, l'acide méthacrylique, l'hydroxyéthyle acrylate, les acrylamides (tels que le butyle acrylamide ou l'octyle acrylamide), les méthacrylamides, la N-vinyl pyrrolidone, le N-vinyl caprolactame et leurs mélanges. Plus préférentiellement, on utilise l'acide acrylique. Ces monomères peuvent augmenter l'adhésion par mise en place d'interactions de type Van der Waals sur des supports polaires. D'autre part, ils peuvent aussi contribuer à la cohésion de la masse par interactions dipôle-dipôle ou ponts hydrogène.

La bande adhésive est de préférence moussée, c'est-à-dire obtenue par la dispersion d'un gaz dans une phase condensée, que la phase gaz soit apportée directement ou par l'intermédiaire de solides (composés générateurs de gaz, de billes polymères expansibles, de microbilles de verre). Il peut s'agir par exemple d'une mousse acrylique réticulée prise entre deux masses adhésives acryliques réticulées, l'effet mousse étant obtenu par utilisation de microbilles de verre. Les principaux modes d'obtention de PSA « moussés » sont donc par exemple l'injection directe de gaz, l'ajout de microsphères polymère expansibles, l'addition de microbilles de verre (poreuses ou non), l'ajout d'agents moussants chimiques, l'évaporation de solvant.

Des PSA connus sous la désignation « VHB » (Very High Bond) sont proposés par la société 3M, sont conformables aux surfaces non planes et sont utilisables pour les besoins de l'invention, comme par exemple le « VHB4955 ». Les bandes adhésives haute performance « VHB » sont des rubans d'assemblage constitués d'une masse homogène d'adhésif acrylique moussée. Traditionnellement utilisés dans la construction, ils offrent un pouvoir d'adhésion élevé sur une variété de substrats et proposent des épaisseurs allant jusqu'à 3 mm. La contrainte étant répartie dans la totalité de l'épaisseur, ces produits absorbent un maximum d'énergie lors de chocs, vibrations, ou contraintes mécaniques. Ils sont indiqués pour des applications présentant des défauts de planéité ou de rugosité ainsi que pour des applications en extérieur et nécessitant étanchéité.

## Exemples

Composition de caoutchouc de la couche P :

La composition de caoutchouc est à base de :

- 100 pce d'élastomère diénique
- 1 pce de péroxyde de dicumyle (peroxyde de bis(1-phényl-1-méthyléthyl))
- de 0 à 50% en volume par rapport au volume total de la composition de caoutchouc de charges inorganiques piézoélectriques.

Charges inorganiques piézoélectriques : $BaTiO_3$ : diamètre moyen 500nm ou 700nm, densité 5,85g/cm$^3$ - Inframat Advanced Materials

L'élastomère diénique est un copolymère styrène-butadiène non fonctionnalisé, SBR (styrène-butadiène rubber) non fonctionnalisé, ayant 26,5% en poids de motif styrène par rapport au poids total du copolymère et 24% molaire de motif 1,2 de butadiène par rapport à la partie butadiénique et ayant une température de transition vitreuse, Tg, de - 48°C.

La température de transition vitreuse, Tg, est mesurée de manière connue par DSC (Differential Scanning Calorimetry), selon la norme ASTM D3418 de 1999.

Le SBS non fonctionnalisé a une masse moléculaire moyenne en nombre, Mn, variant de 100 000 à 150 000 g/mol.

La microstructure du SBR (répartition relative des unités butadiène 1,2-vinyl, 1,4-trans et 1,4-cis) et la détermination quantitative du taux massique de styrène dans le SBR sont déterminées par spectroscopie proche infrarouge (NIR). Le principe de la méthode repose sur la loi de Beer-Lambert généralisée à un système multi-composants. La méthode étant indirecte, elle fait appel à un étalonnage multivarié [Vilmin, F.; Dussap, C.; Coste, N. Applied Spectroscopy 2006, 60, 619-29] réalisé à l'aide d'élastomères étalons de composition déterminée par RMN [13]C. Le taux de styrène et la microstructure sont alors calculés à partir du spectre NIR d'un film d'élastomère d'environ 730 μm d'épaisseur. L'acquisition du spectre est réalisée en mode transmission entre 4000 et 6200 cm-$^1$ avec une résolution de 2 cm-$^1$, à l'aide d'un spectromètre proche infrarouge à transformée de Fourier Bruker Tensor 37 équipé d'un détecteur InGaAs refroidi par effet Peltier.

Composition de caoutchouc de la couche E :

Les deux couches E ont la même composition.
La composition de caoutchouc est à base de :

- 100 pce d'élastomère diénique
- 1 pce de péroxyde de dicumyle (peroxyde de bis(1-phényl-1-méthyléthyl))
- 25% en volume par rapport au volume total de la composition de caoutchouc de charges conductrices.

Charges conductrices : noir de carbone Timcal « ENSACO 350G », de surface spécifique (BET mesurée selon la norme ASTM D3037) de 770 $m^2$/g. L'élastomère diénique est le même copolymère styrène-butadiène, SBR, que celui utilisé dans la composition de caoutchouc de la couche P.

Procédé de préparation :

Pour les compositions de caoutchouc des couches E et P, on suit le protocole général suivant :
Les compositions sont fabriquées dans des mélangeurs appropriés, en utilisant deux phases de préparation successives bien connues de l'homme du métier : une première phase de travail ou malaxage thermo-mécanique (parfois qualifiée de phase "non-productive") à haute température, jusqu'à une température maximale (notée Tmax) comprise entre 80°C et 190°C, de préférence entre 80°C et 150°C, suivie d'une seconde phase de travail mécanique (parfois qualifiée de phase "productive") à plus basse température, typiquement inférieure à 80°C, par exemple entre 60°C et 80°C, phase de finition au cours de laquelle est incorporé le système de réticulation; de telles phases ont été décrites par exemple dans les documents EP 501227, EP 735088, WO00/05300, WO00/05301 ou WO02/083782.
A titre d'exemple, la première phase (non-productive) est conduite en une seule étape thermomécanique au cours de laquelle on introduit, dans un mélangeur approprié tel qu'un mélangeur interne usuel, l'élastomère diénique et les charges en un ou plusieurs temps, à l'exception du système de réticulation. La durée totale du malaxage, dans cette phase non-productive, est de préférence comprise entre 2 et 10 minutes.
Après refroidissement du mélange ainsi obtenu, on incorpore alors le système de réticulation à basse température, généralement dans un mélangeur externe tel qu'un mélangeur à cylindres ; le tout est alors mélangé (phase productive) pendant quelques minutes, par exemple entre 5 et 15 minutes.
La composition finale ainsi obtenue est ensuite calandrée, par exemple sous la forme d'une plaque.
La plaque formant la couche P est intercalée entre deux plaques formant les couches E. Pour la réalisation du dispositif, un moule de cuisson est utilisé. Sont disposées successivement dans ce moule :

- La couche E sous la forme d'une plaque de dimension 100mm x 100 mm x 1mm (Lxlxe),
- La couche P sous la forme d'une plaque de dimension 100mm x 100 mm x 2mm (Lxlxe),
- La couche E sous la forme d'une plaque de dimension 100mm x 100 mm x 1mm (Lxlxe),

Ensuite ce moule est placé dans une presse à plateaux où les matériaux sont cuits à 170°C sous 12 tonnes de pression pendant 20 minutes.
A l'issue de cette opération, il est tout à fait possible de découper les stratifiés avec un emporte-pièce ou tout autre moyen de découpe pour réaliser un composite piézoélectrique avec ses deux électrodes à la forme et la taille souhaitée.
Eprouvettes pour l'effet du taux de charge et les caractérisations en déformation et en cyclage :
On découpe dans le dispositif obtenu précédemment un parallélépipède de Longueur x Largeur x Epaisseur : 3x1,5x4 (mm)
Conditions de polarisation :

- Temps : 1h
- Température : 100°C
- Champs électrique : 4,5kV/mm

Mesure de la quantité de charge électrique émise :

- DMA Metravib avec mors d'extension spécifique permettant de capter les charges collectées sur les électrodes des composites > Amplificateur de charges > Oscilloscope

- Mode de sollicitation : extension variable de 0,01% à 2% en fonction de la matrice

Mesures en déformation et cyclage :
Machine de traction type Instron avec mors d'extension spécifique

Dans les exemples 1 à 3 qui suivent, le dispositif comprenant une couche P intercalée entre deux couches E a été testé et caractérisé. Dans l'exemple 4, la couche P seule a été testée et caractérisée.

Exemple 1. Effet du taux de charge

Dans le dispositif testé, la couche P comprend 0%, 33% ou 50% en volume, par rapport au volume total de la composition de caoutchouc, de charges inorganiques piézoélectriques de diamètre 500 nm. Chaque couche E est identique et telle que décrite précédemment.
Particules de 500 nm - Sollicitation dynamique : 2% déformation à 1Hz

Tableau 1

|  | 1 | 2 | 3 |
|---|---|---|---|
| Composition de caoutchouc formant la couche P | | | |
| Elastomère (pce) | 100 | 100 | 100 |
| $BaTiO_3$ (pce) | 0 | 194,7 | 295 |
| Péroxyde (pce) | 1 | 1 | 1 |
| Fraction vol. $BaTiO_3$ (%vol) | 0 | 33 | 50 |
| Taux de charges restitué | | | |
| d31 (pC/N) | 0 | 4,1 | 17,3 |

Conclusion : Le taux de particules céramiques ferroélectriques a un impact direct sur le taux de charge électrique restitué pour une même déformation. Le comportement piézoélectrique du dispositif est observé dès 33% en volume de charges piézoélectriques. Les différents diamètres de particules permettent d'obtenir des composites ayant une activité piézoélectrique.

Exemple 2. Caractérisation en déformation

Dans le dispositif testé, la couche P comprend 33% en volume, par rapport au volume total de la composition de caoutchouc, de charges inorganiques piézoélectriques de diamètre 500 nm. Chaque couche E est identique et telle que décrite précédemment.
Le but de cette caractérisation est d'observer l'évolution de la charge électrique délivrée par le matériau en fonction de la force appliquée en traction sur un nombre de cycles choisi.
Ces mesures se faisant sur des cycles, il a fallu déterminer une fréquence constante pour la réalisation de ces cycles, de manière à ce que la variation de la fréquence n'influe pas sur la valeur de la charge délivrée. Ainsi, comme la machine d'essai à une vitesse maximale de fonctionnement (d'environ 1 m/min), la fréquence a été choisi de manière à ce que la machine aille à sa vitesse maximale lors de la mesure pour la déformation maximum (initialement de 50%).
Les conditions de mesures ont donc été les suivantes :

- Température : ~25°C
- Pression : ~1 atm (~101 kPa)
- Fréquence : 0,3 Hz
- Nombre de cycles : 30

Les mesures ont donc été réalisées pour différentes valeurs de déformation et sont rapportées dans le tableau suivant :

Tableau 2

| déformation (%) | $d_{31}$ moy (pC/N) |
|---|---|
| 0,97 | 4,06 |
| 1,95 | 4,07 |
| 2,43 | 4,11 |
| 2,99 | 4,19 |
| 3,5 | 4,22 |
| 4,48 | 4,23 |
| 4,98 | 4,27 |
| 5,48 | 4,3 |
| 7,47 | 4,3 |
| 9,9 | 4,34 |
| 15 | 4,25 |
| 19,88 | 4,15 |
| 24,93 | 4,13 |
| 29,94 | 4,1 |

Ainsi, en analysant les résultats, il peut être conclut que le coefficient piézoélectrique ne varie pas pour des déformations comprises entre 0 et 35%. Cependant, pour une déformation de 50%, une légère baisse du coefficient peut être remarquée, mais il n'est pas possible de déterminer si cela est une propriété intrinsèque du matériau ou si cela est dû aux pertes électromécaniques qui deviennent de plus en plus importantes avec la déformation.

Exemple 3. Caractérisation en cyclage

Dans le dispositif testé, la couche P comprend 33% en volume, par rapport au volume total de la composition de caoutchouc, de charges inorganiques piézoélectriques de diamètre 500 nm. Chaque couche E est identique et telle que décrite précédemment.

Dans un premier temps, les essais se sont faits à l'échelle d'un week-end avec les conditions suivantes :

• Fréquence : 1 Hz
• Déformation : 1,25%
• Pression : ~1 atm (~ 101 kPa)
• Température : ~25°C

Les mesures se sont donc effectuées dans ces conditions constantes sans interruption pendant plusieurs heures (40 000 cycles) et sont rapportées dans le tableau suivant :

Tableau 3

| Nb de cycles | $d_{31}$ moy (pC/N) |
|---|---|
| 1 | 4,1 |
| 10 | 4,12 |
| 100 | 4,27 |
| 1000 | 4,3 |
| 2000 | 4,22 |
| 3000 | 4,1 |
| 4000 | 4,19 |

(suite)

| Nb de cycles | $d_{31}$ moy (pC/N) |
|---|---|
| 5000 | 4,15 |
| 10 000 | 4,25 |
| 15 000 | 4,13 |
| 20 000 | 4,08 |
| 25 000 | 4,23 |
| 30 000 | 4,08 |
| 40 000 | 4,13 |

Ainsi, il apparaît clairement que, à température ambiante, le cyclage, n'a pas d'effet sur l'endurance au niveau piézoélectrique du matériau. De plus, des mesures ont également été réalisées à 40°C, 60°C, 80°C et 100°C. Et pour ces caractérisations, le matériau ne subit pas de variation notable de son coefficient $d_{31}$.

Exemple 4 : propriétés mécaniques de la couche P

Dans cet exemple, les propriétés mécaniques de la couche P seule sont testées. la couche P comprend 33% en volume, par rapport au volume total de la composition de caoutchouc, de charges inorganiques piézoélectriques de diamètre 500 nm.

Rhéogramme : mesure du S'

La méthode de mesure de S' utilise une machine de rhéologie RPA 2000LV (rhéomètre à disque oscillant) équipée du capteur de viscosité standard 200 in.lbs (22.6 Nm). La machine RPA permet de solliciter en torsion un échantillon de matériau enfermé dans une chambre (ou enceinte) à parois biconiques.

Pour réaliser la mesure, on dépose un échantillon de matériau d'environ 30mm de diamètre et de masse d'environ 5g dans l'enceinte du RPA (Un volume total de 8 cm$^3$ est considéré comme optimal ; la quantité est suffisante lorsqu'une petite quantité d'échantillon s'échappe de chaque côté de l'enceinte et est visible à la fin du test). De préférence, le matériau est préalablement découpé dans une feuille de ce matériau. Dans le cas où cette feuille de matériau n'a pas une épaisseur suffisante, on peut empiler les sections de cette feuille de matériau.

On réalise une opération de cuisson en appliquant à l'échantillon enfermé dans la chambre une température de 170°C pendant 40 min avec un cisaillement de 2,78% (soit un angle de 0,19°). On mesure à chaque instant l'état de cuisson du mélange, tel que donné par le module S' en fonction du temps. Ces premières étapes sont conformes aux conditions proposées dans la norme ISO 3417 de février 2009, qui donne les paramètres de préparation et de tests pour analyser un temps de réticulation d'un échantillon dans le rhéomètre.

Les étapes de mise en forme et de réticulation de l'échantillon et de mesure de S' sont faites sans intervention, par programmation de la machine RPA.

Les mesures sont effectuées à 170°C avec un rhéomètre à chambre oscillante, selon la norme DIN 53529 - partie 3 (juin 1983). L'évolution du couple rhéométrique en fonction du temps décrit l'évolution de la rigidification de la composition par suite de la réaction de réticulation. Les mesures sont traitées selon la norme DIN 53529 - partie 2 (mars 1983). Ti est le délai d'induction, c'est-à-dire le temps nécessaire au début de la réaction de réticulation. T$\alpha$ (par exemple T95) est le temps nécessaire pour atteindre une conversion de $\alpha$%, c'est-à-dire $\alpha$% (par exemple 95%) de l'écart entre les couples minimum et maximum.

Les résultats sont reportés dans le tableau suivant :

Tableau 4

| temps (min) | S' (dN.m) |
|---|---|
| 1 | 8 |
| 2 | 12 |
| 3 | 16 |
| 4 | 18 |

(suite)

| temps (min) | S' (dN.m) |
|---|---|
| 5 | 20 |
| 10 | 24 |
| 15 | 26 |
| 20 | 26 |

Cette mesure permet de déterminer le temps de cuisson optimum pour du matériau formant la couche P. Etant donné que ce temps est de 15 minutes, il est tout à fait compatible avec une cuisson pneumatique.

Propriétés dynamiques :

Les propriétés dynamiques G* et tan($\delta$)max sont mesurées sur un vis-coanalyseur (Metravib V A4000), selon la norme ASTM D 5992 - 96. On enregistre la réponse d'un échantillon de composition réticulée (éprouvette cylindrique de 4 mm d'épaisseur et de 400 mm$^2$ de section), soumis à une sollicitation sinusoïdale en cisaillement simple alterné, à la fréquence de 10Hz, à 60°C, selon la norme ASTM D 1349 - 99. On effectue un balayage en amplitude de déformation crête à crête de 0,1 à 100% (cycle aller), puis de 100% à 1 % (cycle retour). Les résultats exploités sont le module complexe de cisaillement dynamique (G*) sur le cycle retour.

Les propriétés dynamiques sont mesurées sur un viscoanalyseur (Metravib VA4000), selon la norme ASTM D 5992-96. On enregistre la réponse d'un échantillon de composition réticulé (éprouvette cylindrique de 4 mm de hauteur et de 400 mm$^2$ de section), soumis à une sollicitation sinusoïdale en cisaillement simple alterné, à la fréquence de 10Hz, à 60°C. On effectue un balayage en amplitude de déformation de 0,1% à 100% (cycle aller), puis de 100% à 0,1% (cycle retour). Les résultats exploités sont le module complexe de cisaillement dynamique G*.

Les résultats sont donnés dans le tableau suivant :

Tableau 5

| déformation (%) | G* (Mpa) |
|---|---|
| 0,1 | 4,5 |
| 0,2 | 4,5 |
| 0,3 | 4,5 |
| 0,4 | 4,5 |
| 0,5 | 4,3 |
| 1 | 4 |
| 3 | 3,9 |
| 5 | 3,5 |
| 10 | 3,2 |
| 11 | 3 |
| 50 | 2,8 |
| 100 | 2,5 |

Grâce à cette mesure, il est mis en évidence que le matériau piézoélectrique formant la couche P est déformable jusqu'à 100% de déformation, permettant ainsi d'envisager son incorporation en pneumatique.

**Revendications**

**1.** Dispositif piézoélectrique (11,12) comprenant au moins une couche P composite piézoélectrique intercalée entre deux couches E composites conductrices, chaque couche E formant une électrode,

23

- la couche P étant une composition de caoutchouc à base :

- de plus de 50 parties en poids pour cent parties en poids d'élastomère, pce, d'élastomère diénique,
- d'un système de réticulation,
- d'au moins 5% en volume, par rapport au volume total de la composition de caoutchouc, de charges inorganiques piézoélectriques ;

- chaque couche E étant une composition de caoutchouc à base :

- d'au moins 50 pce d'élastomère diénique,
- d'un système de réticulation,
- de charges conductrices ;

l'élastomère diénique de la couche P étant co-réticulé avec l'élastomère diénique de chaque couche E.

2. Dispositif selon la revendication 1, **caractérisé en ce que** dans la couche P le taux de charges inorganiques piézoélectriques varie de 5% à 80% en volume par rapport au volume total de matrice élastomère, avantageusement de 5% à 60%, plus avantageusement encore de 5% à 50 %.

3. Dispositif selon l'une quelconque des revendications précédentes **caractérisé en ce que** dans la couche P la taille des charges inorganiques piézoélectriques varie de 50 nm à 500 $\mu$m.

4. Dispositif selon l'une quelconque des revendications précédentes **caractérisé en ce que** les charges inorganiques piézoélectriques sont des céramiques piézoélectriques, avantageusement des oxydes ferroélectriques, avantageusement ayant une structure perovskite.

5. Dispositif selon l'une quelconque des revendications précédentes **caractérisé en ce que** les charges inorganiques piézoélectriques sont choisies dans le groupe comprenant les charges de titanate de baryum, titanate de plomb, titano-zirconate de plomb (PZT), niobate de plomb, niobate de lithium et niobate de potassium, avantageusement les charges inorganiques piézoélectriques sont des charges de titanate de baryum.

6. Dispositif selon l'une quelconque des revendications précédentes, **caractérisé en ce que** le système de réticulation de la composition de caoutchouc de la couche P et/ou d'une ou chaque composition de caoutchouc de la couche E est choisi dans le groupe constitué par les peroxydes et leurs mélanges, en particulier les peroxydes organiques.

7. Dispositif selon la revendication précédente, **caractérisé en ce que** le peroxyde organique est choisi dans le groupe constitué par les peroxydes de dialkyle, les monoperoxycarbonates, les peroxydes de diacyle, les perox-ycétales, les peroxyesters, et leurs mélanges.

8. Dispositif selon l'une quelconque des revendications précédentes, **caractérisé en ce que** dans une ou chaque couche E les charges conductrices sont du noir de carbone graphité ou partiellement graphité.

9. Procédé de préparation d'un dispositif selon l'une quelconque des revendications 1 à 8 polarisé, comprenant une étape de polarisation à une température de polarisation inférieure d'au moins 5°C à la température de Curie, Tc, la plus faible des charges inorganiques piézoélectriques.

10. Procédé de préparation d'un dispositif selon l'une quelconque des revendications 1 à 8 comprenant les étapes suivantes :

(a1) Placer au moins une couche P composite piézoélectrique entre deux couches E, identiques ou différentes, composites conductrices,
pour obtenir un assemblage ;
(a2) Appliquer une pression sur l'assemblage obtenu suite à l'étape (a1) ;
(a3) Réticuler l'assemblage pour obtenir ledit dispositif.

11. Procédé de préparation selon la revendication précédente, comprenant une étape de polarisation (a4) du dispositif obtenu suite à l'étape (a3), avantageusement à une température de polarisation inférieure d'au moins 5°C à la température de Curie, Tc, la plus faible des charges inorganiques piézoélectriques.

**12.** Procédé selon l'une quelconque des revendications 10 à 11, **caractérisé en ce que** la couche composite piézoélectrique est préparée par un procédé comprenant les étapes suivantes :

(b1) incorporer à un élastomère diénique, dans un mélangeur, une charge inorganique piézoélectrique en malaxant thermomécaniquement le tout, en une ou plusieurs fois, jusqu'à atteindre une température maximale comprise entre 80°C et 190°C ;
(b2) refroidir l'ensemble à une température inférieure à 80°C ;
(b3) incorporer ensuite un système de réticulation ;
(b4) malaxer le tout jusqu'à une température maximale inférieure à 80°C ;
(b5) calandrer ou extruder la composition de caoutchouc ainsi obtenue sous la forme d'une bande.

**13.** Procédé selon l'une quelconque des revendications 10 à 12, **caractérisé en ce que** chaque couche E composite conductrice est préparée par un procédé comprenant les étapes suivantes :

(c1) incorporer à un élastomère diénique, dans un mélangeur, une charge conductrice en malaxant thermomécaniquement le tout, en une ou plusieurs fois, jusqu'à atteindre une température maximale comprise entre 110°C et 190°C ;
(c2) refroidir l'ensemble à une température inférieure à 100°C ;
(c3) incorporer ensuite un système de réticulation ;
(c4) malaxer le tout jusqu'à une température maximale inférieure à 110°C ;
(c5) calandrer ou extruder la composition de caoutchouc ainsi obtenue sous la forme d'une bande.

**14.** Pneumatique (1) comprenant un dispositif selon l'une quelconque des revendications 1 à 8.

**15.** Utilisation du dispositif selon l'une quelconque des revendications 1 à 8, en association avec un capteur.

**Patentansprüche**

**1.** Piezoelektrische Vorrichtung (11,12), umfassend mindestens eine piezoelektrische Verbundschicht P, die zwischen zwei leitenden Verbundschichten E angeordnet ist, wobei jede Schicht E eine Elektrode bildet,

- wobei die Schicht P eine Kautschukzusammensetzung ist auf Basis:

- von mehr als 50 Gewichtsteilen auf hundert Gewichtsteile Elastomer, phr, eines Dien-Elastomers,
- eines Vernetzungssystems,
- von mindestens 5 Volumen-%, bezogen auf das Gesamtvolumen der Kautschukzusammensetzung, piezoelektrischen anorganischen Füllstoffen;

- wobei jede Schicht E eine Kautschukzusammensetzung ist auf Basis:

- von mindestens 50 phr eines Dien-Elastomers,
- eines Vernetzungssystems,
- von leitenden Füllstoffen;

wobei das Dien-Elastomer der Schicht P mit dem Dien-Elastomer jeder Schicht E co-vernetzt ist.

**2.** Vorrichtung nach Anspruch 1, **dadurch gekennzeichnet, dass** in der Schicht P der Anteil an piezoelektrischen anorganischen Füllstoffen von 5 % bis 80 Volumen-%, bezogen auf das Gesamtvolumen der Elastomermatrix, vorteilhafterweise von 5 % bis 60 %, noch vorteilhafterweise von 5 % bis 50 % variiert.

**3.** Vorrichtung nach einem der vorhergehenden Ansprüche, **dadurch gekennzeichnet, dass** in der Schicht P die Größe der piezoelektrischen anorganischen Füllstoffe von 50 nm bis 500 um variiert.

**4.** Vorrichtung nach einem der vorhergehenden Ansprüche, **dadurch gekennzeichnet, dass** die piezoelektrischen anorganischen Füllstoffe piezoelektrische Keramiken, vorteilhafterweise ferroelektrische Oxide sind, die vorteilhafterweise ein Perowskit-Gefüge aufweisen.

**5.** Vorrichtung nach einem der vorhergehenden Ansprüche, **dadurch gekennzeichnet, dass** die piezoelektrischen anorganischen Füllstoffe aus der Gruppe gewählt sind, die die Füllstoffe aus Bariumtitanat, Bleititanat, Blei-Zirkonat-Titanat (PZT), Bleiniobat, Lithiumniobat und Kaliumniobat umfasst, die piezoelektrischen anorganischen Füllstoffe vorteilhafterweise Füllstoffe aus Bariumtitanat sind.

**6.** Vorrichtung nach einem der vorhergehenden Ansprüche, **dadurch gekennzeichnet, dass** das Vernetzungssystem der Kautschukzusammensetzung der Schicht P und/oder einer oder jeder Kautschukzusammensetzung der Schicht E aus der Gruppe gewählt ist, die aus den Peroxiden und ihren Mischungen, insbesondere den organischen Peroxiden besteht.

**7.** Vorrichtung nach dem vorhergehenden Anspruch, **dadurch gekennzeichnet, dass** das organische Peroxid aus der Gruppe gewählt ist, die aus den Dialkylperoxiden, den Monoperoxycarbonaten, den Diacylperoxiden, den Peroxiketalen, den Peroxyestern und ihren Mischungen besteht.

**8.** Vorrichtung nach einem der vorhergehenden Ansprüche, **dadurch gekennzeichnet, dass** in einer oder jeder Schicht E die leitenden Füllstoffe graphitierter oder teilweise graphitierter Ruß sind.

**9.** Verfahren zur Herstellung einer Vorrichtung nach einem der Ansprüche 1 bis 8, umfassend einen Schritt der Polarisation bei einer Polarisationstemperatur, die um mindestens 5 °C unter der niedrigsten Curie-Temperatur, Tc, der piezoelektrischen anorganischen Füllstoffe liegt.

**10.** Verfahren zur Herstellung einer Vorrichtung nach einem der Ansprüche 1 bis 8, umfassend die folgenden Schritte:

(a1) Platzieren mindestens einer piezoelektrischen Verbundschicht P zwischen zwei identischen oder unterschiedlichen leitenden Verbundschichten E, um einen Verbund zu erhalten;
(a2) Ausüben eines Drucks auf den nach dem Schritt (a1) erhaltenen Verbund;
(a3) Vernetzen des Verbunds, um die Vorrichtung zu erhalten.

**11.** Verfahren zur Herstellung nach dem vorhergehenden Anspruch, umfassend einen Schritt der Polarisation (a4) der nach dem Schritt (a3) erhaltenen Vorrichtung, vorteilhafterweise bei einer Polarisationstemperatur, die um mindestens 5 °C unter der niedrigsten Curie-Temperatur, Tc, der piezoelektrischen anorganischen Füllstoffe liegt.

**12.** Verfahren nach einem der Ansprüche 10 bis 11, **dadurch gekennzeichnet, dass** die piezoelektrische Verbundschicht mit einem Verfahren hergestellt wird, das die folgenden Schritte umfasst:

(b1) Einarbeiten eines piezoelektrischen anorganischen Füllstoffs in ein Dien-Elastomer in einem Mischer, indem das Ganze ein oder mehrmals thermomechanisch geknetet wird, bis eine maximale Temperatur zwischen 80 °C und 190 °C erreicht ist;
(b2) Abkühlen des Ganzen auf eine Temperatur unter 80 °C;
(b3) anschließendes Einarbeiten eines Vernetzungssystems;
(b4) Kneten des Ganzen bis zu einer maximalen Temperatur unter 80 °C;
(b5) Kalandrieren oder Extrudieren der so erhaltenen Kautschukzusammensetzung in Form eines Streifens.

**13.** Verfahren nach einem der Ansprüche 10 bis 12, **dadurch gekennzeichnet, dass** jede leitende Verbundschicht E mit einem Verfahren hergestellt wird, das die folgenden Schritte umfasst:

(c1) Einarbeiten eines leitenden Füllstoffs in ein Dien-Elastomer in einem Mischer, indem das Ganze ein oder mehrmals thermomechanisch geknetet wird, bis eine maximale Temperatur zwischen 110 °C und 190 °C erreicht ist;
(c2) Abkühlen des Ganzen auf eine Temperatur unter 100 °C;
(c3) anschließendes Einarbeiten eines Vernetzungssystems;
(c4) Kneten des Ganzen bis zu einer maximalen Temperatur unter 110 °C;
(c5) Kalandrieren oder Extrudieren der so erhaltenen Kautschukzusammensetzung in Form eines Streifens.

**14.** Reifen (1), umfassend eine Vorrichtung nach einem der Ansprüche 1 bis 8.

**15.** Verwendung der Vorrichtung nach einem der Ansprüche 1 bis 8 in Kombination mit einem Sensor.

**Claims**

1. Piezoelectric device (11, 12) comprising at least one piezoelectric composite layer P inserted between two conductive composite layers E, each layer E forming an electrode:

    - the layer P being a rubber composition based:

        - on more than 50 parts by weight, per hundred parts by weight of elastomer, phr, of diene elastomer,
        - on a crosslinking system,
        - on at least 5% by volume, with respect to the total volume of the rubber composition, of piezoelectric inorganic fillers;

    - each layer E being a rubber composition based:

        - on at least 50 phr of diene elastomer,
        - on a crosslinking system,
        - on conductive fillers;

    the diene elastomer of the layer P being co-crosslinked with the diene elastomer of each layer E.

2. Device according to Claim 1, **characterized in that**, in the layer P, the content of piezoelectric inorganic fillers varies from 5% to 80% by volume, with respect to the total volume of elastomer matrix, advantageously from 5% to 60%, more advantageously still from 5% to 50%.

3. Device according to either one of the preceding claims, **characterized in that**, in the layer P, the size of the piezoelectric inorganic fillers varies from 50 nm to 500 $\mu$m.

4. Device according to any one of the preceding claims, **characterized in that** the piezoelectric inorganic fillers are piezoelectric ceramics, advantageously ferroelectric oxides, advantageously having a perovskite structure.

5. Device according to any one of the preceding claims, **characterized in that** the piezoelectric inorganic fillers are selected from the group comprising barium titanate, lead titanate, lead zirconate titanate (PZT), lead niobate, lithium niobate and potassium niobate fillers; advantageously, the piezoelectric inorganic fillers are barium titanate fillers.

6. Device according to any one of the preceding claims, **characterized in that** the crosslinking system of the rubber composition of the layer P and/or of one or each rubber composition of the layer E is selected from the group consisting of peroxides and their mixtures, in particular organic peroxides.

7. Device according to the preceding claim, **characterized in that** the organic peroxide is selected from the group consisting of dialkyl peroxides, monoperoxycarbonates, diacyl peroxides, peroxyketals, peroxyesters and their mixtures.

8. Device according to any one of the preceding claims, **characterized in that**, in one or each layer E, the conductive fillers are graphitized or partially graphitized carbon black.

9. Process for the preparation of a polarized device according to any one of the claims 1 to 8, comprising a stage of polarization at a polarization temperature lower by at least 5°C than the lowest Curie temperature, Tc, of the piezoelectric inorganic fillers.

10. Process for the preparation of a device according to any one of the claims 1 to 8, comprising the following stages:

    (a1) placing at least one piezoelectric composite layer P between two identical or different conductive composite layers E, in order to obtain an assembly;
    (a2) applying a pressure to the assembly obtained following stage (a1);
    (a3) crosslinking the assembly in order to obtain said device.

11. Preparation process according to the preceding claim, comprising a stage of polarization (a4) of the device obtained following stage (a3), advantageously at a polarization temperature lower by at least 5°C than the lowest Curie temperature, Tc, of the piezoelectric inorganic fillers.

12. Process according to either one of Claims 10 and 11, **characterized in that** the piezoelectric composite layer is prepared by a process comprising the following stages:

(b1) incorporating a piezoelectric inorganic filler in a diene elastomer, in a mixer, everything being thermomechanically kneaded, in one or more goes, until a maximum temperature of between 80°C and 190°C is reached;
(b2) cooling the combined mixture to a temperature of less than 80°C;
(b3) subsequently incorporating a crosslinking system;
(b4) kneading everything up to a maximum temperature of less than 80°C;
(b5) calendering or extruding the rubber composition thus obtained in the form of a strip.

13. Process according to any one of Claims 10 to 12, **characterized in that** each conductive composite layer E is prepared by a process comprising the following stages:

(c1) incorporating a conductive filler in a diene elastomer, in a mixer, everything being thermomechanically kneaded, in one or more goes, until a maximum temperature of between 110°C and 190°C is reached;
(c2) cooling the combined mixture to a temperature of less than 100°C;
(c3) subsequently incorporating a crosslinking system;
(c4) kneading everything up to a maximum temperature of less than 110°C;
(c5) calendering or extruding the rubber composition thus obtained in the form of a strip.

14. Tyre (1) comprising a device according to any one of Claims 1 to 8.

15. Use of the device according to any one of Claims 1 to 8, in combination with a sensor.

Fig. 1

Fig. 2

Fig. 3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2015134061 A
- WO 2016157092 A
- EP 2654094 A
- DE 112016000917 T5
- WO 03095244 A, Michelin
- US 20110074564 A
- JP 2013225608 A
- EP 692493 A
- EP 501227 A
- EP 735088 A
- WO 0005300 A
- WO 0005301 A
- WO 02083782 A

**Littérature non-brevet citée dans la description**

- **CAPSAL et al.** *Journal of non-crystalline solids,* 2010, vol. 356, 629-634
- **FURUKAWA et al.** *Jpn. J. Appl. Phys.,* 1976, vol. 15, 2119
- **HANNER et al.** *Ferroelectrics,* 1989, vol. 100, 255-260
- **LIU et al.** *Materials Science and Engineering,* 2006, vol. 127, 261-266
- **RUJIJANAGUL et al.** *Journal of Materials Science Letters,* 2001, vol. 20, 1943-1945
- **VILMIN, F. ; DUSSAP, C. ; COSTE, N.** *Applied Spectroscopy,* 2006, vol. 60, 619-29